# EUROPEAN PATENT APPLICATION

(11) **EP 2 131 405 A2**
(43) Date of publication of application: **09.12.2009**
(21) Application number: 09007366.9
(22) Date of filing: 03.06.2009
(51) Int. Cl.: H01L 35/30, H01L 35/32

(54) **Thermoelectric module device and heat exchanger used therein**

(30) Priority: 06.06.2008 JP 2008149663
(71) Applicant: Yamaha Corporation, Hamamatsu-shi, Shizuoka-ken (JP)
(72) Inventor: Horio, Yuma, Mamamatsu-shi Shizuoka-ken (JP)
(74) Representative: Wagner, Karl H.

(57) **Abstract**

A thermoelectric module device (10) absorbs heat from the hot side, and transfers the heat to the cold side; the thermoelectric module device is constituted by a heat sink (11) on the hot side, another heat sink (16) on the cold side and a series of Peltier elements (PLT), and the series of Peltier elements (PLT) is formed from pairs of semiconductor elements (14) of different conductivity types, endoergic metal electrodes (15) and exoergic metal electrodes (13); since the entire major surfaces of heat sinks (11/ 16) are not available for the endoergic metal electrodes (15) and exoergic metal electrodes (13) due to fitting holes (11e) and vapor-proof sealing walls, the ratio of area (13a/ 15a) occupied with the metal electrodes (13/ 15) to available area and the ratio of area not available for the metal electrodes (13/ 15) to entire major surface are not less than 50 % and not greater than 20 %.

## Description

### FIELD OF THE INVENTION

This invention relates to a thermoelectric module device and, more particularly, to a thermoelectric module device having an array of Peltier elements and a heat exchanger connected to an endoergic substrate and/ or an exoergic substrate of the thermoelectric module device.

### DESCRIPTION OF THE RELATED ART

The thermoelectric module device has an array of p-type semiconductor elements and n-type semiconductor elements provided between endoergic electrodes on an endoergic substrate and exoergic electrodes on an exoergic substrate, and the endoergic electrodes and exoergic electrodes make the p-type semiconductor elements and n-type semiconductor elements alternately connected in series. While current is flowing through the p-type semiconductor elements and n-type semiconductor elements, the p-type semiconductor elements and n-type semiconductor elements cause temperature difference between the endoergic substrate and the exoergic substrate. In order to increase the amount of heat to be transferred, a heat exchanger is connected to the endoergic substrate and/ or the exoreic substrate.

A typical example of the heat exchanger is disclosed in Japan Patent Application laid-open No. 2003-332642. Figure 1A shows the prior art thermoelectric module device disclosed in the Japan Patent Application laid-open.

The prior art thermoelectric module device is designated in its entirety by reference numeral 50. The prior art thermoelectric module device 50 includes a heat exchanger or a heat sink 51, an electrically insulating layer 52, metalized layers 53, conductive metal electrodes 50a and semiconductor elements 55, i.e., p-type semiconductor elements 55a and n-type semiconductor elements 55b. The p-type semiconductor element 55a, n-type semiconductor element 55b, exoergic metal electrodes 54 and endoergic metal electrode 56 form a Peltier element 50a. The heat sink 51 is made of aluminum, and the electrically insulating layer 52 is made of alumite. The electrically insulating layer 52 is formed on the heat sink 51. The conductive metal electrodes 50a are categorized into two groups, i.e., exoergic electrodes 54 and endoergic electrodes 56. The metalized layers 53 are formed of copper on a major surface of the electrically insulating layer 52 through galvanizing, and are laid on a pattern identical with that of the exoergic metal electrodes 54.

The exoergic metal electrodes 54 are provided on the metalized layers 53, respectively, and a pair of p-type semiconductor element 55a and n-type semiconductor element 55b is held in contact with each of the exoergic metal electrodes 54. The p-type semiconductor element 55a and n-type semiconductor element 55b on one of the exoergic metal electrode 54 are respectively connected to the n-type semiconductor element 55b of an adjacent exoergic metal electrode 54 through the endoergic metal electrode 56 and the p-type semiconductor element 55a on another exoergic metal electrode 54 through another endoergic metal electrode 56. Thus, the p-type semiconductor elements 55a and n-type semiconductor elements 55b are alternately connected in series through the exoergic metal electrodes 54 and endoergic metal electrodes 56.

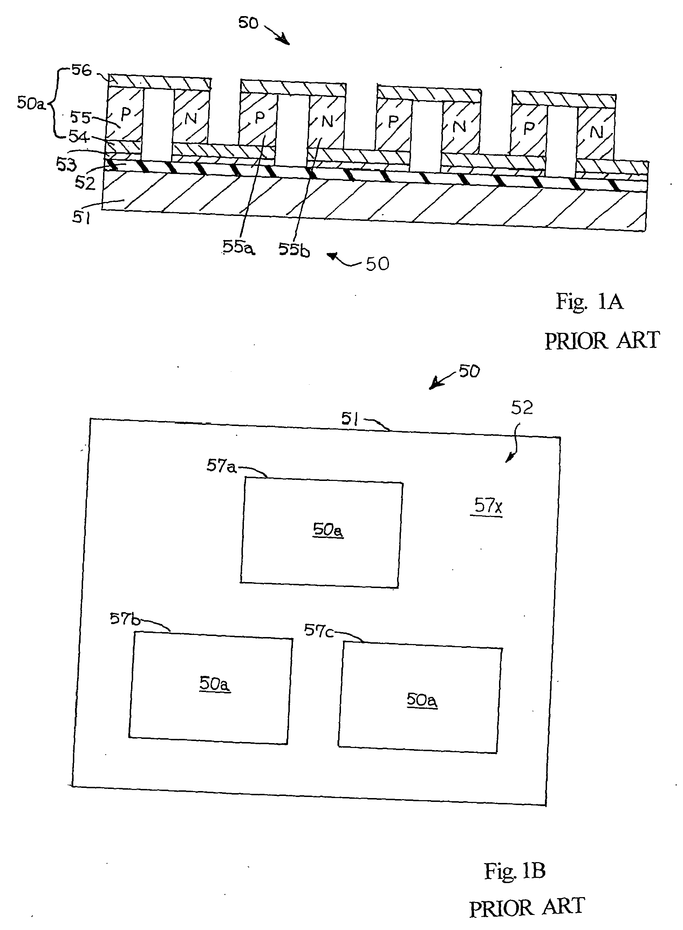

Though not shown in figure 1A, a source of potential is connected between the exoergic metal electrode 54 at one end of the series combination of p-type semiconductor elements 55a and n-type semiconductor elements 55b and another exoergic metal electrode 54 at the other end of the series combination. While current is flowing through the series combination of p-type semiconductor elements 55, conductive metal electrodes 50a and n-type semiconductor elements 55b, the endoergic metal electrodes 56 becomes higher in temperature than the exoergic metal electrodes 54 and, accordingly, the heat sink 51.

The thermoelectric module devices such as the thermoelectric module device 50 are sold in the market, and form parts of various consumer products.

The electrically insulating layer 52 of alumite is formed over the major surface of the heat sink 51, and is sporadically occupied by the Peltier elements 50a as shown in figure 1B. An area, which is occupied by the Peltier elements 50a, is referred to as a "unit occupied area 57a, 57b or 57c", and an area enclosed with an envelope where the unit occupied areas 57a, 57b and 57c are found is referred to as an "occupied area." An area impossible to be occupied by the Peltier element 50a is referred to as a "non-occupied area. Reference sign "57x" designates an entire major surface of the heat sink 51.

A problem is encountered in the prior art thermoelectric module devices in that the prior art thermoelectric module devices do not exhibit expected endoergic characteristics or expected exoergic characteristics. In other words, the users require large-sized thermoelectric module devices for achieving the expected endoergic characteristics or expected exoergic characteristics.

### SUMMARY OF THE INVENTION

It is therefore an important object of the present invention to provide a thermoelectric module device, which exhibits good endoergic characteristics or good exoergic characteristics.

It is also an important object of the present invention to provide a heat exchanger, which makes the thermoelectric module device exhibit the good endoergic characteristics or the good exoergic characteristics.

The present inventor contemplated the problem, and noticed that manufacturers had not taken the ratio of occupied area 57a, 57b and 57c and the ratio of non-occupied area into account. The present inventor deduced that the non-occupied area caused the heat sink 51 to have undesirable temperature dispersion. Even though the heat sink 51 had the major surface wide enough to exhibit good endoergic characteristics, the non-uniform temperature dispersion made the endoergic characteristics poorer than that on the design sheet.

The present inventor investigated the prior art thermoelectric module devices for the temperature dispersion on the major surface, and found that serious temperature dispersion took place in the prior art thermoelectric module devices.

The present inventor further conducted experiments to see whether or not the ratio of occupied area and ratio of non-occupied area had serious influence on the temperature dispersion. The present inventor confirmed that the ratio of occupied area and ratio of non-occupied area had serious influence on the temperature dispersion and, accordingly, the heat transfer characteristics of thermoelectric module device, and further found the critical values of ratios.

In accordance with one aspect of the present invention, there is provided a thermoelectric module device for transferring heat from a cold side to a hot side comprising a first heat sink having a thermally conductive property and an electrically insulating property and having a major surface and a heat exchanging surface serving as one of the cold side and hot side, a second heat sink having a thermally conductive property and an electrically insulating property and having another major surface and another heat exchanging surface serving as the other of said cold the and hot side, and a group of thermoelectric elements provided between the major surface and the aforesaid another major surface, occupying an occupied area in the major surface and another occupied area in the aforesaid another major surface and applied with voltage so as to transfer heat between the first heat sink and the second heat sink, the major surface and the aforesaid another major surface have an available area possible to be occupied by the group of thermoelectric elements and another available area possible to be occupied by the group of thermoelectric elements, respectively, and a ratio between the occupied area and the available area and a ratio between the aforesaid another occupied area and the aforesaid another available area are equal to or greater than 50 percent.

In accordance with another aspect of the present invention, there is provided a heat exchanger used for a group of thermoelectric elements comprising a mounting portion having a major surface containing an available area possible to be occupied by the group of thermoelectric elements and a heat exchanging surface held in contact with medium at certain temperature different from the temperature of the major surface, and a ratio between the available area and an occupied area occupied by the group of thermoelectric elements is equal to or greater than 50 percent.

### BRIEF DESCRIPTION OF THE DRAWINGS

The features and advantages of the thermoelectric module device and heat exchanger will be more clearly understood from the following description taken in conjunction with the accompanying drawings, in which
Fig. 1A is a cross sectional view showing the structure of the prior art thermoelectric module device disclosed in the Japan Patent Application laid-open,
Fig. 1B is a plane view showing the layout of the Peltier elements on the electrically insulating layer of the prior art thermoelectric module device,
Figs. 2A to 2C are schematic side views showing the structures of a thermoelectric module device of the present invention at different steps in a fabrication process,
Fig. 3A is a schematic plane view showing the layout of lower electrodes on an electrically insulating layer of the thermoelectric module device,
Fig. 3B is a schematic plane view showing the layout of upper electrodes interconnecting semiconductor elements on the lower electrodes,
Fig. 4 is a schematic view showing a sample of the thermoelectric module device in an experiment for measuring the maximum heat absorption,
Fig. 5 is a view showing the maximum heat absorption in terms of a ratio of non-occupied area,
Figs. 6A to 6C are schematic side views showing the structures of another thermoelectric module device of the present invention at different steps in a fabrication process,
Fig. 7A is a schematic plane view showing the layout of lower electrodes on an electrically insulating layer of the thermoelectric module device,
Fig. 7B is a schematic plane view showing the layout of upper electrodes interconnecting semiconductor elements on the lower electrodes,
Fig. 8 is a schematic view showing a sample of the thermoelectric module device in an experiment for measuring the maximum heat absorption,
Fig. 9 is a graph showing the maximum heat absorption in terms of a ratio of occupied area,
Figs. 10A to 10C are schematic side views showing the structures of yet another thermoelectric module device of the present invention at different steps in a fabrication process,
Fig. 11A is a schematic plane view showing the layout of lower electrodes of the thermoelectric module device,
Fig. 11B is a schematic plane view showing the layout of upper electrodes of the thermoelectric module device,
Fig. 12 is a schematic view showing a sample of the thermoelectric module device in an experiment for measurement of maximum heat absorption,
Fig. 13 is a graph showing the maximum heat absorption in terms of a ratio of occupied area,
Fig. 14 is a schematic plane view showing a groove for a vapor-proof sealing wall,
Fig. 15 is a graph showing the maximum heat absorption in terms of a ratio of non-occupied area obtained through an experiment on the sample of thermoelectric module device, and ,
Fig. 16 is a graph showing the maximum heat absorption in terms of a ratio of non-occupied area obtained through an experiment.

### DESCRIPTION OF THE PREFERRED EMBODIMENTS

A thermoelectric module device of the present invention is used for transferring heat from a cold side to a hot side, and largely comprises a first heat sink, a second heat sink and a group of thermoelectric elements. The group of thermoelectric elements is sandwiched between the first heat sink and a second heat sink. While electric current flows through the group of thermoelectric elements, the group of thermoelectric elements makes one of the first and second heat sink and the other of the first and second heat sink descend and ascend in temperature so that the cold side and hot side take place.

The first heat sink is made of material, which has a thermally conductive property and an electrically insulating property, and has a major surface and a heat exchanging surface. The second heat sink is also made of material, which has a thermally conductive property and an electrically insulating property, and has another major surface and another heat exchanging surface.

The group of thermoelectric elements is provided between the major surface of first heat sink and the aforesaid another major surface of second heat sink. One end of the group of thermoelectric elements occupies an occupied area in the major surface, and the other end of the group of thermoelectric elements occupies another occupied area in the aforesaid another major surface. While voltage is being applied to the group of thermoelectric elements, the cold side and hot side respectively take place in the heat exchanging surfaces, and heat is transferred between the first heat sink and the second heat sink.

The major surface and the aforesaid another major surface have an available area and another available area, respectively. It is possible for the groups of thermoelectric elements to occupy the available area and the aforesaid another available area, because any other facilities do not occupy the available area and aforesaid another available area. The area occupied by the other facilities is called as "non-occupied area" so that the available area is equal to the difference between the area of major surface and the non-occupied area. "Occupied area" is defined as an area in the major surface or aforesaid another major area occupied by the group of thermoelectric elements. Note that the group of thermoelectric elements occupies the occupied area. Even if a vacant area is found among the thermoelectric elements, the vacant area forms a part of the occupied area. In case where the thermoelectric elements are arranged in rows and columns, the occupied area is equal to the area enclosed with an envelope surface where the side surfaces of thermoelectric elements in the outermost rows and the end surfaces of thermoelectric elements in the outermost columns are coplanar.

The present inventor discovered that a large amount of heat was transferred between the cold side and the hot side on the condition that the ratio between the occupied area and the available area and the ratio between the aforesaid another occupied area and the aforesaid another available area were equal to or greater than 50 percent. For this reason, the thermoelectric module device of the present invention fulfills this condition. The reason why the large amount of heat was transferred was that the temperature dispersion on the heat exchanging surfaces became gentle.

The present inventor further discovered that the critical value of the ratio between the non-occupied area and the area of major surface/ another major surface. In case where the ratio between the non-occupied area and the area of major surface/ another major surface was equal to or less than 20 percent, the samples exhibits good heat transferring characteristics.

In case where the thermoelectric module device fulfilled both conditions, the heat transferring characteristics were further enhanced.

### First Embodiment

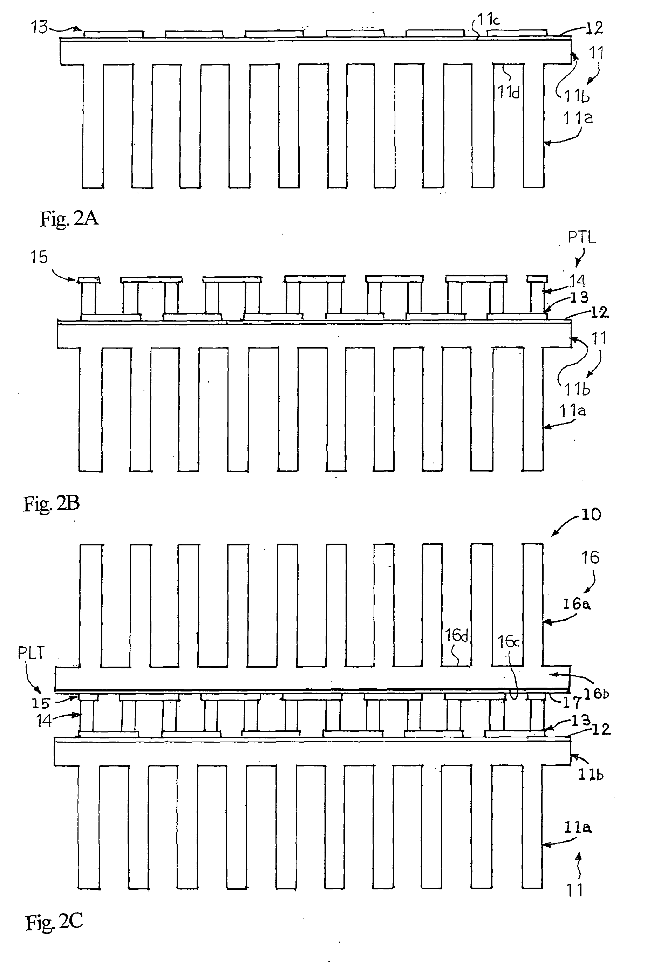

Figs. 2A to 2C show the structures of a thermoelectric module device 10 according to the present invention at different steps in a fabrication process. While current is flowing through the thermoelectric module device 10, a code side and a hot side take place in the thermoelectric module device 10. However, the cold side and hot side are dependent on the direction of current. For this reason, the electrodes are not modified with terms "endoergic" and "exoergic" in the following description.

As shown in figure 2C, the thermoelectric module device 10 largely comprises a first heat sink 11, a second heat sink 16 and an array of Peltier elements PLT. The Peltier elements PLT of array are electrically connected in series so as to form a series combination of Peltier elements PLT, and the array of Peltier elements PLT is sandwiched between the first heat sink 11 and the second heat sink 16. The first heat sink 11 and second heat sink 16 serve as heat exchangers. Though not shown figures 2A to 2C, power supply cables are connected to one of the Peltier elements PLT at one end of the series combination and another Peltier element at the other end of the series combination.

The first heat sink 11 is made of highly heat conductive material such as, for example, copper, copper alloy, aluminum or aluminum alloy, and has fin portions 11a, a mounting portion 11b and an electrically insulating layer 12. The mounting portion 11b has a major surface 11c and another major surface 11d, which is reverse to the major surface 11c. The major surface 11c of mounting portion 11b is covered with the electrically insulating layer 12, and the fin portions 11a project from the major surface 11d at intervals.

The electrically insulating layer 12 is made of insulating material such as, for example, insulating synthetic resin, filler-containing insulating synthetic resin or insulating alloy. Examples of the insulating synthetic resin are polyimide resin or epoxy resin, and an example of insulating alloy is alumite. The filler is expected to enhance the heat conductivity of electrically insulating layer 12, and is, by way of example, alumina powder, i.e., Al₂O₃ powder, aluminum nitride powder, i.e., AIN powder, magnesium oxide powder, i.e., MgO powder or silicon carbide powder, i.e., SiC powder. The powder has the grain size, i.e., mean diameter equal to or less than 15 µm. The filler is dispersed in the insulating synthetic resin such as, for example, the polyimide resin and epoxy resin before the electrically insulating layer 12 is laminated on the major surface 11c. The electrically insulating layer 12 has thickness ranging from 10 µm to 100 µm.

Metal electrodes 13 are formed on the electrically insulating layer 12 as shown in figure 2A, and are arranged in matrix as will be hereinlater described.

The second heat sink 16 is made of aluminum, and also has fin portions 16a, a mounting portion 16b and an electrically insulating layer 17. The mounting portion 16b has a major surface 16c and another major surface 16d, and the major surface 16d is reverse to the major surface 16c. The major surface 16c of mounting portion 16b is covered with the electrically insulating layer 17, and the fin portions 16a project from the major surface 16d at intervals. Thus, the second heat sink 16 is similar in structure to the first heat sink 11 shown in figure 2A except for the metal electrodes 13.

The electrically insulating layer 17 is also made of insulating material such as, for example, insulating synthetic resin, filler-containing insulating synthetic resin or insulating alloy. Examples of the insulating synthetic resin are polyimide resin or epoxy resin, and an example of insulating alloy is alumite. The filler is, by way of example, alumina powder, i.e., Al₂O₃ powder, aluminum nitride powder, i.e., AlN powder, magnesium oxide powder, i.e., MgO powder or silicon carbide powder, i.e., SiC powder. The powder has the grain size equal to or less than 15 µm. The filler is dispersed in the insulating synthetic resin such as, for example, the polyimide resin and epoxy resin before the electrically insulating layer 17 is laminated on the major surface 16c. The electrically insulating layer 17 has thickness ranging from 10 µm to 100 µm.

Subsequently, the Peltier elements PTL are fabricated on the first heat sink 11 as shown in figure 2B. The array of Peltier elements PTL is fabricated from two types of semiconductor elements 14, i.e., p-type semiconductor elements and n-type semiconductor elements, metal electrodes 15 and the metal electrodes 13. The metal electrodes 13 and 15 are made of copper or copper alloy, and have thickness ranging from 70 µm to 200 µm.

The semiconductor elements 14 of one conductivity type, i.e., p-type or n-type are paired with the semiconductor elements 14 of the other conductivity type, i.e., n-type or p-type, and the pairs of semiconductor elements 14 are respectively soldered at the lower ends thereof to the metal electrodes 13 and at the upper ends thereof to the metal electrodes 15 so that the semiconductor elements 14 of each pair are connected to the associated metal electrodes 13 and 15. However, the semiconductor elements 14 of each pair are not directly in contact with one another.

The semiconductor element 14 of one conductivity type and semiconductor element 14 of the other conductivity type on each metal electrode 13 are connected to one another through the metal electrode 13, and are connected to the semiconductor element of the other conductivity type on an adjacent metal electrode 13 and semiconductor element of one conductivity type on another adjacent metal electrode 13 through the metal electrodes 15, respectively except for the semiconductor elements 14 on the metal electrodes 13 at both ends of the series combination. The power supply cables are connected to the metal electrodes 13 at both ends of the series combination, and dc voltage is applied to the series of semiconductor elements 14. The endoergic metal electrodes 13 at both ends of the series combination are formed with terminal portions for the power supply cables.

In this instance, the semiconductor elements 14 are made of p-type compound semiconductor and n-type compound semiconductor. Since sintered product of the compound semiconductor in Bi-Te series exhibits good performance at room temperature, Bi-Sb-Te compound semiconductor is employed as the p-type compound semiconductor, and Bi-Sb-Te-Se compound semiconductor is employed as the n-type compound semiconductor. The Bi-Sb-Te compound semiconductor is expressed as Bi_{0.5}Sb_{1.5}Te₃, and the Bi-Sb-Te-Se compound semiconductor is expressed as Bi_{1.9}Sb_{0.1}Te_{2.6}Se_{0.4}.

The semiconductor elements 14 are formed from melted p-type compound semiconductor and melted n-type compound semiconductor as follows. The melted p-type compound semiconductor and melted n-type compound semiconductor are respectively formed into p-type compound semiconductor flakes and n-type compound semiconductor flakes through a liquid quenching method. The p-type compound semiconductor flakes and n-type compound semiconductor flakes are subjected to a hot pressing so that a p-type compound semiconductor bulk and an n-type compound semiconductor bulk are obtained. The p-type compound semiconductor bulk is cut into p-type compound semiconductor columns, and the n-type compound semiconductor bulk is cut into n-type compound semiconductor columns. The p-type compound semiconductor columns and n-type compound semiconductor columns measure 1.35 millimeters in length, 1.35 millimeters in width and 1.5 millimeters in height. Both end surfaces of each p-type compound semiconductor column and both end surfaces of each n-type compound semiconductor column are plated with nickel, and the semiconductor elements 14 are obtained.

The semiconductor elements 14 are soldered to the metal electrodes 13 and 15. SnSb alloy, AuSn alloy and SnAgCu alloy are available for the soldering.

Finally, the second heat sink 16 is connected to the array of Peltier elements PLT as shown in figure 2C. In detail, the second heat sink 16 is turned over, and the electrically insulating layer 17 is opposed to the metal electrodes 15. The electrically insulating layer 17 is made brought into contact with the metal electrodes 15, and is connected to the metal electrodes 15.

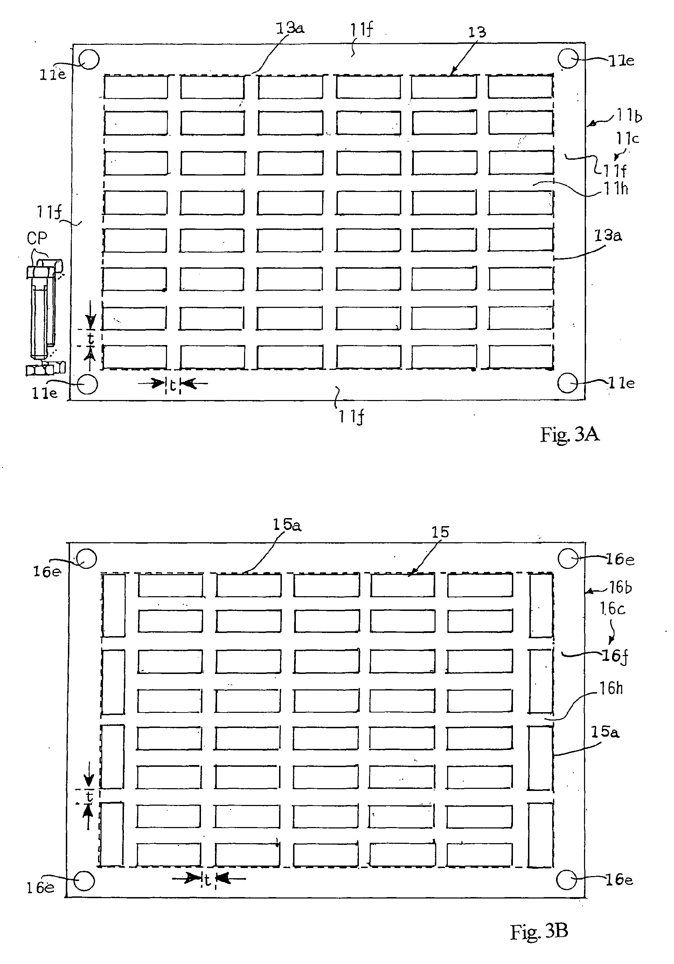

The mounting portion 11b has a rectangular parallelepiped configuration, and fitting holes 11e are formed at the corners of the mounting portion 11b as shown in figure 3A. In the following description, term "major surface" expresses not only the major surface 11c, 11d, 16c or 16d but also the top surface of electrically insulating layer 12 or 17 because of the fact that the major surfaces 11c/ 11d or 16c/ 16d are equal in area to the top surface of electrically insulating layer 12 or 17.

While the first heat sink 11 is being assembled, coupling members CP such as, for example, bolts and nuts occupy the fitting holes 11e, and the manufacturer can not form any electrode in the corner areas because of the fitting holes 11e. For this reason, it is impossible to form the metal electrodes 13 in the corner areas, and the corner areas serve as the non-occupied area. If other sorts of facilities such as, for example, grooves for vapor-proof sealing walls are formed on the major surface 11c, the area occupied by the facilities also forms a part of the non-occupied area. The non-occupied area is defined as a part of the major surface of mounting portion 11b physically impossible to be occupied by the electrode 13. Although peripheral areas 11f between the fitting holes 11e are vacant in this instance, the non-occupied area does not contain the peripheral areas 11f.

Although the grooves for the vapor-proof searing walls are formed in the heat sinks 11 and 16, the grooves and vapor-proof searing walls are omitted for the sake of simplicity.

The metal electrodes 13 are formed in an area 11h inside an envelope surface 13a where the side surfaces and end surfaces of outermost metal electrodes 13 are coplanar. The area 11h serves as the occupied area. Thus, the occupied area is defined as an area where the matrix of metal electrodes 13 occupies.

The non-occupied area is to be equal to or less than 20 percent of the major surface 11c in accordance with the present invention. In this instance, the total of corner areas is 7 percent of the major surface 11c. On the other hand, the occupied area is to be equal to or greater than 50 percent of an available area, which is defined as an area equal to the difference between the major surface 11c and the non-occupied area, in accordance with the present invention. In this instance, the area 11h is greater than 50 percent of the available area.

In the area 11h, i.e., the occupied area, the metal electrodes 13 are arranged in rows and columns, i.e., the matrix at intervals "t". The metal electrodes 13 have rectangular top surfaces, and the rectangular top surfaces measure 3 millimeters in length and 1.8 millimeters in width. The distance "t" is to be less than the width of 1.8 millimeters.

The mounting portion 16b has a rectangular parallelepiped configuration, and fitting holes 16e are formed at the corners of the mounting portion 11b as shown in figure 3B. While the second heat sink 16 is being assembled, the coupling members CP occupy the fitting holes 16e, and the manufacturer can not assign the corner areas to the electrodes 15 because of the fitting holes 16e. For this reason, the corner areas serve as the non-occupied area. The non-occupied area is also defined as a part of the major surface of mounting portion 11b physically impossible to be occupied by the electrode 15. Although peripheral areas 16f between the fitting holes 16e are vacant, the non-occupied area does not contain the peripheral areas 16f.

The metal electrodes 13 occupy an area 16h inside an envelope surface 13a where the side surfaces of outermost metal electrodes 15 are coplanar. The area 16h serves as the occupied area. Thus, the occupied area is also defined as an area where the matrix of metal electrodes 15 occupies.

The non-occupied area is to be equal to or less than 20 percent of the major surface 16c in accordance with the present invention. In this instance, the total of corner areas is 7 percent of the major surface 16c. On the other hand, the occupied area is to be equal to or greater than 50 percent of an available area, which is defined as an area equal to the difference between the major surface 11c and the non-occupied area, in accordance with the present invention. In this instance, the area 16h is greater than 50 percent of the available area.

In the area 16h, i.e., the occupied area, the metal electrodes 15 are arranged in rows and columns, i.e., the matrix at intervals "t". The metal electrodes 15 have rectangular top surfaces, and the rectangular top surfaces measure 3 millimeters in length and 1.8 millimeters in width. The distance "t" is to be less than the width of 1.8 millimeters.

The thermoelectric module device 10 described hereinbefore is available for a temperature control on gas. In the temperature control, the fins 16a of second heat sink 16 are exposed to the gas to be temperature controlled, and potential difference is applied between the cables (not shown) and, accordingly, the series of semiconductor elements 14. Then, current flows through the series of semiconductor elements 14, and temperature difference takes place between the first heat sink 11 and the second heat sink 16. The second heat sink 16 is lower in temperature than the first heat sink 11 so that the thermal energy is transferred from the gas to the fins 16a of second heat sink 16. On the other hand, the first heat sink 11 is raised in temperature, and the thermal energy is radiated from the fins 11a to the environment around the fins 11a.

Samples of the thermoelectric module device 10 were fabricated as follows. Firstly, the component parts of thermoelectric module device 10 were prepared. Air-cooled heat sinks 11, which were corresponding to the first heat sink 11, were prepared. The air-cooled heat sinks 11 had respective adhesive electrically insulating layers 12 and respective sets of plural fins 11a projecting from the surfaces reverse to the electrically insulating layers 12, and were to be used for heat radiation. The metallic portion of air-cooled heat sink 11 was made of aluminum, and the major surface 11c measured 100 millimeters in length and 100 millimeters in width. The fins 11a were 35 millimeters in height.

Similarly, air-cooling heat sinks 16, which were corresponding to the second heat sink 12, were prepared. The air-cooling heat sinks 16 were used for absorption of heat. The air-cooling heat sinks 16 had respective adhesive electrically insulating layers 17 and respective sets of plural fins 16a projecting from the reverse surfaces as similar to the heat sinks 11.

Moreover, exoergic metal electrodes 13, which were corresponding to the metal electrodes 13, endoergic metal electrodes 15, which were corresponding to the metal electrodes 15, plural p-type semiconductor elements, which were corresponding to selected ones of the semiconductor elements 14, and plural n-type semiconductor elements, which were corresponding to the others of the semiconductor elements 14, were prepared.

The metallic portion of air-cooling heat sink 16 was made of aluminum, and the major surface 16c measured 100 millimeters in length and 100 millimeters in width. The fins 16a were 35 millimeters in height.

The adhesive electrically insulating layers 12 of air-cooled heat sinks 11 and the adhesive electrically insulating layers 17 of air-cooling heat sinks 16 were made from filler-containing polyimide resin layers, filler-containing epoxy resin layers and the multiple-layered structure of alumite layers and filler-containing synthetic resin layers, i.e., the filler-containing polyimide resin layers and/ or filler-containing epoxy resin layers. Al₂O₃ powder, AlN powder, MgO powder and SiC powder were used as the filler. The metallic portions of air-cooled heat sinks 11 and the metallic portions of air-cooling heat sink 16 were made of the highly heat conductive metal and highly heat conductive alloy, i.e., copper, aluminum, copper alloy and aluminum alloy.

The adhesive electrically insulating layers 12 and 17 had been prepared as sheets of filler-containing synthetic resin. The sheets of filler-containing synthetic resin were put on the major surfaces of metallic portions or the major surface of alumite layer, and, thereafter, were pressed to the metallic portions or alumite layers so as to clad the metallic portions or alumite layers with them. Otherwise, the metallic portions were coated with paste of filler-containing synthetic resin, and the paste was solidified.

The exoergic metal electrodes 13 and endoergic metal electrodes 15 were made of copper and copper alloy. The exoergic metal electrodes 13 and endoergic metal electrodes 15 were 3 millimeters in length and 1.8 millimeters in width, and had thickness of 70 µm to 200 µm.

The p-type semiconductor element and n-type semiconductor elements were made from the above-described compound semiconductors, and each of the p-type semiconductor elements and n-type semiconductor elements had both end surfaces plated with nickel layers.

The exoergic metal electrodes 13 were laid on the pattern shown in figure 2A, and were adhered to the adhesive electrically insulating layers 12. Subsequently, the p-type semiconductor elements and n-type semiconductor elements were put on the exoergic metal electrodes 13, and were spaced from one another on the exoergic metal electrodes 13. The p-type semiconductor elements and n-type semiconductor elements were soldered to the exoergic metal electrodes 13. The solder was selected from the group consisting of SnSb alloy, AuSn alloy and SnAgCu alloy. The endoergic metal electrodes 15 were soldered to the p-type semiconductor elements and the n-type semiconductor elements so that the p-type semiconductor elements and n-type semiconductor elements were alternately connected in series. Upon completion of soldering, the incomplete structure was same as that shown in figure 2B.

The distance "t" between the adjacent electrodes was different among the samples, and the ratio between the occupied area and the available area was also different among the samples. 420 pairs of p-type semiconductor elements and n-type semiconductor elements were soldered to the metal electrodes 13 and 15.

Subsequently, the air-cooling heat sink 16 was opposed to the air-cooled heat sink 11, and the endoergic metal electrodes 15 were brought into contact with the adhesive electrically insulating layer 17. The endoergic metal electrodes 15 were adhered to the adhesive electrically insulating layer 17, and the structure became similar to that shown in figure 3C.

The present inventor selected four sample groups A1, A2, A3 and A4 from the samples for investigation. As described hereinbefore, the heat sinks 11 and 16 of all the samples of the groups A1, A2, A3 and A4 had the metallic portions of aluminum, and measured 100 mm in length and 100 mm in width, and the height of fins 11a and 16a was 35 millimeters. However, the adhesive electrically insulating layers 12 and 17 were different as follows.

The sample group A1 had the adhesive electrically insulating layers 12 and 17 of 15 µm in thickness, and the adhesive electrically insulating layers 12 and 17 were made of alumina powder-containing polyimide resin. The sample group A2 had the adhesive electrically insulating layers 12 and 17 of 20 µm in thickness, and the adhesive electrically insulating layers 12 and 17 were made of aluminum nitride powder-containing epoxy resin. The sample group A3 had the multiple layered insulating structure 12, and the multiple layered insulating structure had the alumite layer of 10 µm thick and the magnesium oxide powder containing polyimide resin of 100 µm thick. The sample group A4 also had the multiple layered insulating structure 12, and the multiple layered insulating structure had the alumite layer of 10 µm thick and the silicon carbide powder containing polyimide resin of 80 µm thick.

The exoergic metal electrodes 13 and endoergic metal electrodes 15 were made of copper, and measured 3 millimeters in length, 1.8 millimeters in width and 120 µm in thickness. 420 pairs of p-type semiconductor elements and n-type semiconductor elements were soldered to the exoergic metal electrodes 13 and endoergic metal electrode 15. The ratio of non-occupied area to the entire major surface was fixed to 7 percent. The distance "t" between the adjacent metallic electrodes 13 and between the adjacent electrodes 15 was different from one another in each of the groups A1 to A4, and was written in Table 1. The ratio of occupied area to the available area was also written in Table 1.

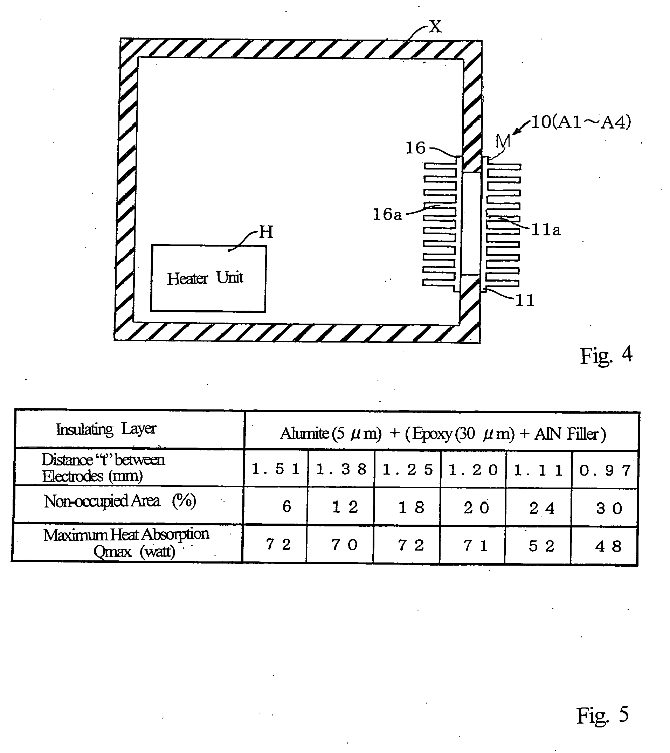

The present inventor further prepared a heat insulating box X shown in figure 4. The heat insulating box X had an inner space where a heater unit H was accommodated. A window was formed for the samples M of thermoelectric module device 10 of groups A1 to A4, and each of the samples M was fitted to the heat insulating box X through the window. The endoergic heat sink 16 are exposed to the inner space of the heat insulating box X, and the exoergic heat sink 11 was exposed to the outside of heat insulating box X. Though not shown in figure 4, fans were provided inside the heat insulating box X and outside the heat insulating box X for forced air cooling.

The present inventor fitted each of the samples M to the heat insulating box X, and drove the heater unit H, and drove the fans (not shown). The present inventor started to supply the current through the series of p-type semiconductor elements and n-type semiconductor elements of the sample M, and measured inside temperature, i.e., the temperature inside the heat insulating box X and outside temperature, i.e., the temperature outside the heat insulating box X.

Although the heater unit H gave the heat to the inner space, the sample M of thermoelectric module device 10 transferred the thermal energy from the endoergic heat sink 16 to the exoergic heat sink 11. The present inventor varied the electric power supplied to the heater unit H, and observed the temperature difference between the inside temperature and the outside temperature. The present inventor looked for the maximum amount of heat generated through the heater unit H at which the inside temperature became equal to the outside temperature. When the inside temperature became equal to the outside temperature, the present inventor determined that the sample M exhibited the maximum heat absorption Qmax. The present inventor defined the maximum heat absorption Qmax in watt as being equal to the maximum amount of heat generated by the heater unit H. The maximum heat absorption was written in Table 1.

**Table 1**

| | | Maximum Heat Absorption Qmax (Watt) | | | | | Electrically Insulating Layers 12, 17 | |
|---|---|---|---|---|---|---|---|---|
| Distance t (mm) | | 0.47 | 0.85 | 1.05 | 1.20 | 1.37 | Material (thickness; mm) | Filler |
| Ratio (%) | | 35 | 45 | 50 | 55 | 60 | | |
| Sample | A1 | 80 | 87 | 110 | 110 | 112 | Polyimide (15) | Al₂O₃ |
| | A2 | 86 | 92 | 111 | 113 | 113 | Epoxy (20) | AlN |
| | A3 | 83 | 87 | 105 | 106 | 106 | alumite (10) + polyimide(100) | MgO |
| | A4 | 80 | 89 | 107 | 107 | 109 | alumite (10) + polyimide(80) | SiC |

In Table 1, term "ratio" means the ratio of the occupied area to the available area, and the available area is (total area of major surface minus non-occupied area). In this experiment, the applied voltage and the amount of flowing current were as follows.

The voltage, which was applied to sample A1, was 24 volts. The amount of current flowing through sample A1 was varied together with the maximum heat absorption Qmax, and was 4.2 amperes at 80 watts, 4.3 amperes at 87 watts, 4.5 amperes at 110 watts, 4.5 amperes at 110 watts and 4.7 amperes at 112 watts.

The voltage, which was applied to sample A2, was also 24 volts. The amount of current flowing through sample A2 was varied together with the maximum heat absorption Qmax, and was 4.1 amperes at 86 watts, 4.1 amperes at 92 watts, 4.5 amperes at 111 watts, 4.4 amperes at 113 watts and 4.3 amperes at 113 watts.

The voltage, which was applied to sample A3, was 24 volts. The amount of current flowing through sample A3 was varied together with the maximum heat absorption Qmax, and was 4.1 amperes at 83 watts, 4.1 amperes at 87 watts, 4.4 amperes at 105 watts, 4.4 amperes at 106 watts and 4.4 amperes at 106 watts.

The voltage, which was applied to sample A4, was also 24 volts. The amount of current flowing through sample A4 was varied together with the maximum heat absorption Qmax, and was 3.9 amperes at 80 watts, 4.2 amperes at 89 watts, 4.4 amperes at 107 watts, 4.5 amperes at 107 watts and 4.3 amperes at 109 watts.

As will be understood from the experience result shown in Table 1, the samples of the sample groups A1, A2, A3 and A4 exhibit the large amount of maximum heat absorption Qmax on the condition that the occupied area is equal to or greater than 50 % of the available area. Note that the distance "t" is shorter than the width of electrodes 13 and 15, i.e., 1.8 millimeters.

The present inventor further prepared samples, which were different in the electrically insulating layers 12 and 17, ratio of non-occupied area and distance "t" from the samples of sample groups A1, A2, A3 and A4. The electrically insulating layers 12 and 17 had the multiple-layered structure, which was constituted by the alumite layer of 5 µm and aluminum nitride powder containing epoxy resin of 30 µm. All the samples had the ratio of occupied area to available area equal to one another. The distance "t" between the adjacent electrodes 13 and 15 and the ratio of non-occupied area to the entire major surface were shown in figure 4. All the samples had the distance "t" shorter than the width of electrodes 13 and 15.

From figure 5, it is understood that the samples exhibit the large amount of maximum heat absorption Qmax on the condition that the ratio of non-occupied area is equal to or less than 20 %.

As will be understood from the experiment results shown in Table 1 and figure 5, the thermoelectric module device 10 exhibits the large amount of maximum heat absorption on the condition that the ratio of occupied area to available area is to be equal to or greater than 50 percent in so far as the ratio of non-occupied area to entire major surface is constant and that the ratio of non-occupied area to entire major surface is to be equal to or less than 20 percent in so far as the ratio of occupied area to available area is constant. The reason why the above-described conditions result in the above-described conditions make the temperature on the heat sinks 11 and 16 uniform.

### Second Embodiment

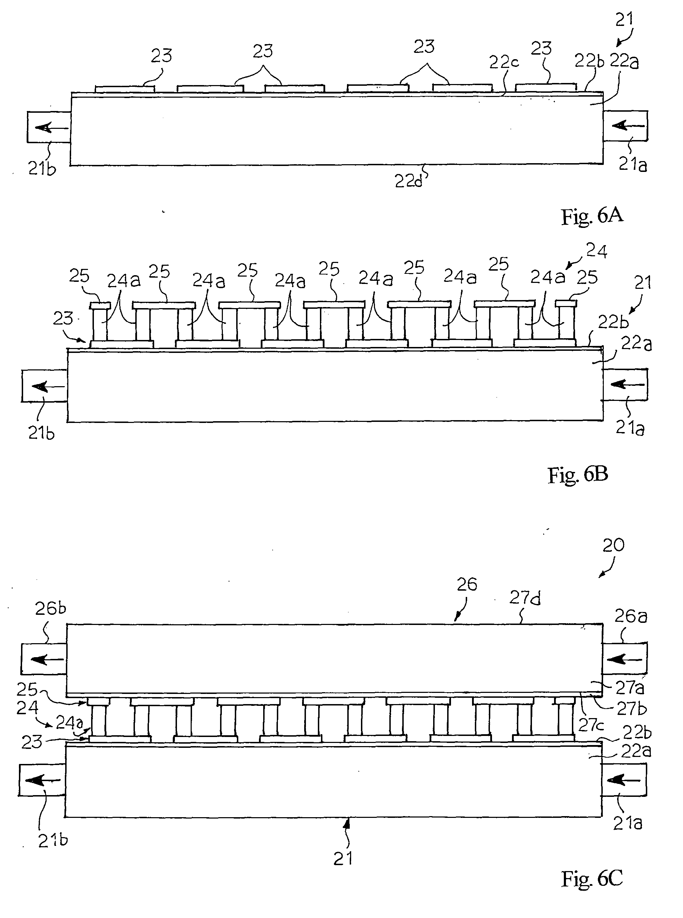

Figures 6A to 6C show intermediate structures another thermoelectric module device 20 of the present invention at different steps of a fabrication process. A difference of the thermoelectric module device 20 from the thermoelectric module device 10 is that a water cooling system is incorporated in the thermoelectric module device 20.

As shown in figure 6C, the thermoelectric module device 20 comprises a water-cooled heat sink 21, a water-cooling heat sink 26 and a series combination 24 of semiconductor elements 24a. The water-cooled heat sink 21 and water-cooling heat sink 26 respectively behave as a water-cooling heat sink and a water-cooled heat sink on the condition that current reversely flows through the series combination 24 of semiconductor elements 24a.

The water-cooled heat sink 21 includes a metallic plate 22a and an electrically insulating layer 22b as shown in figure 6A. The metallic plate 22a is made of highly heat conductive metal, and has a rectangular parallelepiped configuration. The water-cooled heat sink 21 is not formed with any fin. In this instance, the metallic plate 22a is made of aluminum. The major surfaces of metallic plate 22a are designated by reference signs 22c and 22d, respectively, and the major surface 22c is overlaid with the electrically insulating layer 22b. A water conduit is formed in the metallic plate 22a, and the water conduit has water inlets 21a and water outlets 21c. Cooling water flows into the water conduit through the water inlets 21a, and flows out from the water conduit through the water outlets 21c.

The water-cooling heat sink 26 is similar to the water-cooled heat sink 21, and includes a metallic plate 27a and an electrically insulating layer 27b. The metallic plate 27a has a rectangular parallelepiped configuration. A water conduit is formed in the metallic plate 27a, and has water inlets 26a and water outlets 26c. The metallic plate 27a and electrically insulating layer 27b are similar in material and structure to those of the water-cooled heat sink 21, and, for this reason, no further description is incorporated for the sake of simplicity.

The series combination 24 includes metal electrodes 23, semiconductor elements 24a and metal electrodes 25. Both end surfaces of each semiconductor element 24a are plated with conductive metal such as, for example, nickel. The metal electrodes 23 are laid on a matrix on the electrically insulating layer 22b, and the semiconductor elements 24a stand on the metal electrodes 23. The semiconductor elements 24a are categorized into two groups, i.e., a p-conductivity type and an n-conductivity type so that the p-type semiconductor elements 24a and n-type semiconductor elements 24a are incorporated in the series combination 24. The p-type semiconductor elements 24a are respectively paired with the n-type semiconductor elements 24a, and each pair of p-type semiconductor element 24a and n-type semiconductor element 24a is assigned to one of the metal electrodes 23. The p-type semiconductor element 24a and n-type semiconductor element 24a stand on both end portions of the associated metal electrode 23, and are soldered to both end portions. For this reason, the p-type semiconductor element 24a and n-type semiconductor element 24a of each pair is electrically connected to one another through the metal electrode 23. The p-type semiconductor element 24a of each pair is electrically connected to the n-type semiconductor elements 24a on the adjacent metal electrodes 23 through the metal electrodes 25. The metal electrodes 25 are soldered at one ends thereof to the p-type semiconductor elements 24a and at the other ends thereof to the n-type semiconductor elements 24a. As a result, the p-type semiconductor elements 24a and n-type semiconductor elements 24a are alternately connected in series through the metal electrodes 23 and metal electrodes 25 so as to form parts of the series combination 24 as shown in figure 6B. Though not shown in figures 6A to 6C, power supply cables are connected to the metal electrode 23 at one end of the series combination 24 and at the other end of the series combination 24, respectively, and dc potential difference is applied to the series combination 24. The endoergic metal electrodes 23 at both ends of the series combination are formed with terminal portions for the power supply cables.

The electrically insulating layer 22a is made of insulating material such as, for example, insulating synthetic resin, filler-containing insulating synthetic resin or insulating alloy. Examples of the insulating synthetic resin are polyimide resin or epoxy resin, and an example of insulating alloy is alumite. The filler is expected to enhance the heat conductivity of electrically insulating layer 22a, and is, by way of example, alumina powder, i.e., Al₂O₃ powder, aluminum nitride powder, i.e., AlN powder, magnesium oxide powder, i.e., MgO powder or silicon carbide powder, i.e., SiC powder. The powder has the grain size, i.e., mean diameter equal to or less than 15 µm. The filler is dispersed in the insulating synthetic resin such as, for example, the polyimide resin and epoxy resin before the electrically insulating layer 12 is laminated on the major surface 22c. The electrically insulating layer 22b has thickness ranging from 10 µm to 100 µm. In case where the electrically insulating layer 22b is made of insulating alloy, i.e., alumite, it is preferable to laminate the major surface of alumite layer with the filler-containing polyimide resin layer or filler-containing epoxy resin layer. Thus, the electrically insulating layer 22b may have a multiple-layered structure.

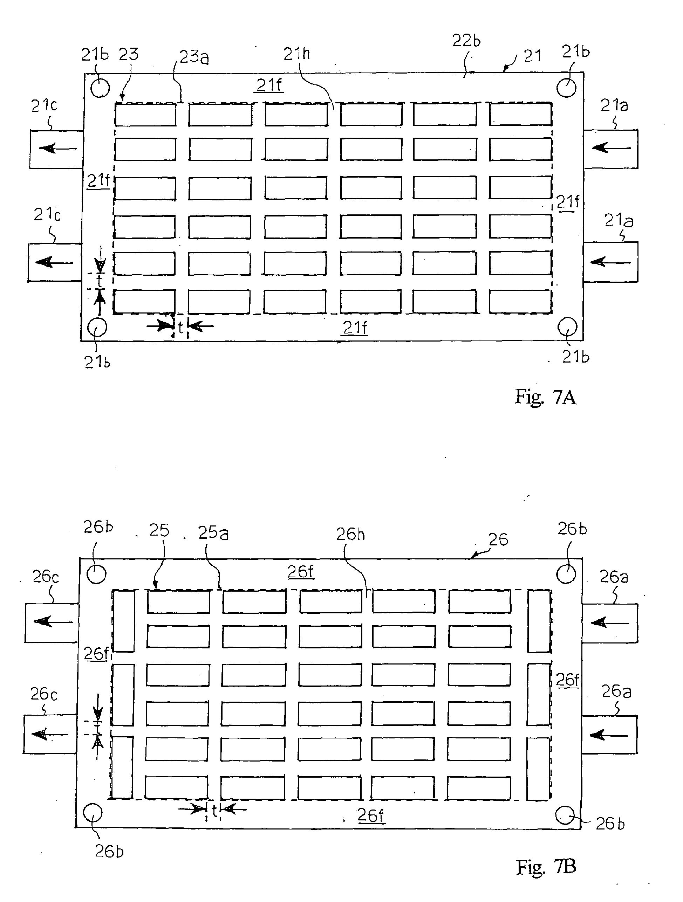

Turning to figures 7A and 7B, the water-cooled heat sink 21 is formed with fitting holes 21b, and the water-cooling heat sink 26 is formed with fitting holes 26b. In the following description, term "major surface also expresses not only the major surface 22c, 22d, 27c or 27d but also the top surface of electrically insulating layer 22b or 27b.

The fitting holes 21b extend in a direction of the thickness of water-cooled heat sink 21, and are exposed to the electrically insulating layer 22b at the four corners of water-cooled heat sink 21 and to the major surface 22d at the four corners. The fitting holes 26b extend in a direction of the thickness of water-cooling heat sink 26, and are exposed to the electrically insulating layer 27b at the four corners of water-cooling heat sink 26 and to the major surface 27d at the four corners. While the water-cooled heat sink 21, water-cooling heat sink 26 and series combination 24 are being assembled, coupling members (not shown) occupy the fitting holes 21b and 26b. For this reason, the manufacturer can not form any electrode in the corner areas because of the fitting holes 11e. It is impossible to form the metal electrodes 23 and 25 in the corner areas so that the corner areas serve as the non-occupied area. If other sorts of facilities are formed on the major surfaces 22c and 27c, the area occupied by the facilities also forms a part of the non-occupied area. The non-occupied area is defined as a part of the major surface physically impossible to be occupied by the electrode 13.

Although peripheral areas 21f and 26f between the fitting holes 21b and between the fitting holes 26b are vacant in this instance, the non-occupied area does not contain the peripheral areas 21f and 26f.

The metal electrodes 23 are formed in an area 21 h inside an envelope surface 23a where the side surfaces and end surfaces of outermost metal electrodes 23 are coplanar. The area 21h serves as the occupied area. Thus, the occupied area is defined as an area where the matrix of metal electrodes 23 occupies.

Similarly, the metal electrodes 25 occupy an area 26h inside an envelope surface 25a where the side surfaces of metal electrodes 25 are coplanar. The area 25h also serves as the occupied area, and the definition of "occupied area" is also applicable to the area 25h.

The non-occupied area is to be equal to or less than 20 percent of the major surface in accordance with the present invention. In this instance, the total of corner areas, i.e., the non-occupied area is 14 percent of the major surface. On the other hand, the occupied area is to be equal to or greater than 50 percent of an available area, which is defined as an area equal to the difference between the major surface and the non-occupied area, in accordance with the present invention. In this instance, the area 21h or 26h is greater than 50 percent of the available area.

In the area 21h, i.e., the occupied area, the metal electrodes 23 are arranged in rows and columns, i.e., the matrix at intervals "t". The metal electrodes forms rows and columns, and the metal electrodes 25 on both sides the rows and columns are turned at right angle. All the metal electrodes 25 form a matrix. The metal electrodes 23 and 25 have rectangular top surfaces, and the rectangular top surfaces measure 3 millimeters in length and 1.8 millimeters in width. The metal electrodes 23 and 25 are made of copper or copper alloy, and the thickness of metal electrodes 23 and 25 is fallen within the range between 70 µm and 200 µm. The distance "t" is to be less than the width of 1.8 millimeters.

In this instance, the semiconductor elements 24a are made from p-type compound semiconductor pieces covered at both end surfaces with the nickel plates and n-type compound semiconductor also covered at both end surfaces with the nickel. Since sintered product of the compound semiconductor in Bi-Te series exhibits good performance at room temperature, Bi-Sb-Te compound semiconductor is employed as the p-type compound semiconductor, and Bi-Sb-Te-Se compound semiconductor is employed as the n-type compound semiconductor. The Bi-Sb-Te compound semiconductor is expressed as Bi_{0.5}Sb_{1.5}Te₃, and the Bi-Sb-Te-Se compound semiconductor is expressed as Bi_{1.9}Sb_{0.1}Te₂.₆Se_{0.4}.

The semiconductor elements 24a are formed from melted p-type compound semiconductor and melted n-type compound semiconductor as follows. The melted p-type compound semiconductor and melted n-type compound semiconductor are respectively formed into p-type compound semiconductor flakes and n-type compound semiconductor flakes through a liquid quenching method. The p-type compound semiconductor flakes and n-type compound semiconductor flakes are subjected to a hot pressing so that a p-type compound semiconductor bulk and an n-type compound semiconductor bulk are obtained. The p-type compound semiconductor bulk is cut into p-type compound semiconductor columns, and the n-type compound semiconductor bulk is cut into n-type compound semiconductor columns. The p-type compound semiconductor columns and n-type compound semiconductor columns measure 1.35 millimeters in length, 1.35 millimeters in width and 1.5 millimeters in height. Both end surfaces of each p-type compound semiconductor column and both end surfaces of each n-type compound semiconductor column are plated with nickel, and the semiconductor elements 24a are obtained.

The semiconductor elements 24a are soldered to the metal electrodes 23 and 25. SnSb alloy, AuSn alloy and SnAgCu alloy are available for the soldering.

Samples of the thermoelectric module device 20 were fabricated as follows. Firstly, the component parts of thermoelectric module device 20 were prepared. Water-cooled heat sinks 21 were prepared, and the air-cooled heat sinks 21 had respective adhesive electrically insulating layers 22b and metallic plates 22a formed with the water conduits, and were to be used for heat transfer to water. The metallic plates of water-cooled heat sinks 21 were made of aluminum, and the major surface 22c measured 120 millimeters in length, 100 millimeters in width and 15 millimeters in thickness. The present inventor confirmed that aluminum alloy was available for the water-cooled heat sink 21.

Exoergic electrodes 23 and endoergic electrodes 25 were made of copper. Copper alloy was available for the exoergic electrodes 23 and endoergic electrodes 25. The exoergic electrodes 23 and endoergic electrodes 25 were 3 millimeters in length and 1.8 millimeters in width, and the thickness of exoergic electrodes 23 and the thickness of endoergic electrodes 25 were fallen within the range from 70 µm to 200 µm. The exoergic electrodes were corresponding to the metal electrodes 23, and the exoergic electrodes were corresponding to the metallic electrodes 25.

Similarly, water-cooling heat sinks 26 were prepared. The water-cooling heat sinks 26 were used for absorption of heat from water. The water-cooling heat sinks 26 had respective adhesive electrically insulating layers 27b and respective metal plates 27a formed with water conduits.

The plural p-type semiconductor elements, which were corresponding to selected ones of the semiconductor elements 24a, and plural n-type semiconductor elements, which were corresponding to the others of the semiconductor elements 24a, were prepared. The p-type semiconductor elements and n-type semiconductor elements were made from the above-described p-type compound semiconductor pieces and n-type compound semiconductor pieces, and nickel plates were plated on both ends of each of the semiconductor elements 24a.

The metal plate 22d was made of aluminum, and the major surface 16c measured 120 millimeters in length and 100 millimeters in width.

The adhesive electrically insulating layers 22b of water-cooled heat sinks 21 and the adhesive electrically insulating layers 27b of water-cooling heat sinks 26 were made from filler-containing polyimide resin layers, filler-containing epoxy resin layers and the multiple-layered structure of alumite layers and filler-containing synthetic resin layers, i.e., the filler-containing polyimide resin layers and/ or filler-containing epoxy resin layers. Al₂O₃ powder, AlN powder, MgO powder and SiC powder were used as the filler.

The adhesive electrically insulating layers 22b and 27b had been prepared as sheets of filler-containing synthetic resin. The sheets of filler-containing synthetic resin were put on the major surfaces of metal plates 22a and 27a, and, thereafter, were pressed to the metal plates so as to clad the metal plates 22a and 27a with them. Otherwise, the metal plates 22a and 27a were coated with paste of filler-containing synthetic resin, and the paste was solidified.

The exoergic metal electrodes 23 were laid on the pattern shown in figure 6A, and were adhered to the adhesive electrically insulating layers 22b. Subsequently, the p-type semiconductor elements and n-type semiconductor elements were put on the exoergic metal electrodes 23, and were spaced from one another on the exoergic metal electrodes 23. The p-type semiconductor elements and n-type semiconductor elements were soldered to the exoergic metal electrodes 23. The solder was selected from the group consisting of SnSb alloy, AuSn alloy and SnAgCu alloy. The endoergic metal electrodes 25 were soldered to the p-type semiconductor elements and the n-type semiconductor elements so that the p-type semiconductor elements and n-type semiconductor elements were alternately connected in series. Upon completion of soldering, the incomplete structure was same as that shown in figure 6B.

The distance "t" between the adjacent electrodes 23/ 25 was different among the samples, and the ratio between the occupied area and the available area was also different among the samples. 540 pairs of p-type semiconductor elements and n-type semiconductor elements were soldered to the metal electrodes 23 and 25.

Subsequently, the water-cooling heat sink 26 was opposed to the water-cooled heat sink 21, and the endoergic metal electrodes 25 were brought into contact with the adhesive electrically insulating layer 27b. The endoergic metal electrodes 25 were adhered to the adhesive electrically insulating layer 27b, and the structure became similar to that shown in figure 6C.

The present inventor selected two sample groups B1 and B2 from the samples for investigation. As described hereinbefore, the water-cooled heat sinks 21 and water-cooling heat sink 26 of all the samples of the groups B1 and B2 had the metal plates 22a and 27a of aluminum, and measured 120 mm in length, 100 mm in width and 15 millimeters in thickness. However, the adhesive electrically insulating layers 22b and 27b were different as follows.

The adhesive insulating layers 22b and 27b of sample group B1 had the multiple-layered structure, and the multiple-layered structure had the alumite layer of 5 µm thick and the aluminum nitride powder-containing polyimide resin layer of 30 µm thick. On the other hand, the adhesive insulating layers 22b and 27b was made magnesium oxide powder-containing epoxy resin, and the thickness of adhesive insulating layers 22b and 27b of sample group B2 is 20 µm.

The exoergic metal electrodes 23 and endoergic metal electrodes 25 were made of copper, and measured 3 millimeters in length, 1.8 millimeters in width and 120 µm in thickness. 540 pairs of p-type semiconductor elements and n-type semiconductor elements were soldered to the exoergic metal electrodes 23 and endoergic electrodes 25.

The ratio of non-occupied area to the entire major surface was fixed to 14 percent. The distance "t" between the adjacent exoergic metallic electrodes 23 and between the adjacent endoergic metal electrodes 25 was different from one another in each of the groups B1 and B2, and was written in Table 2. The ratio of occupied area to the available area was also written in Table 2.

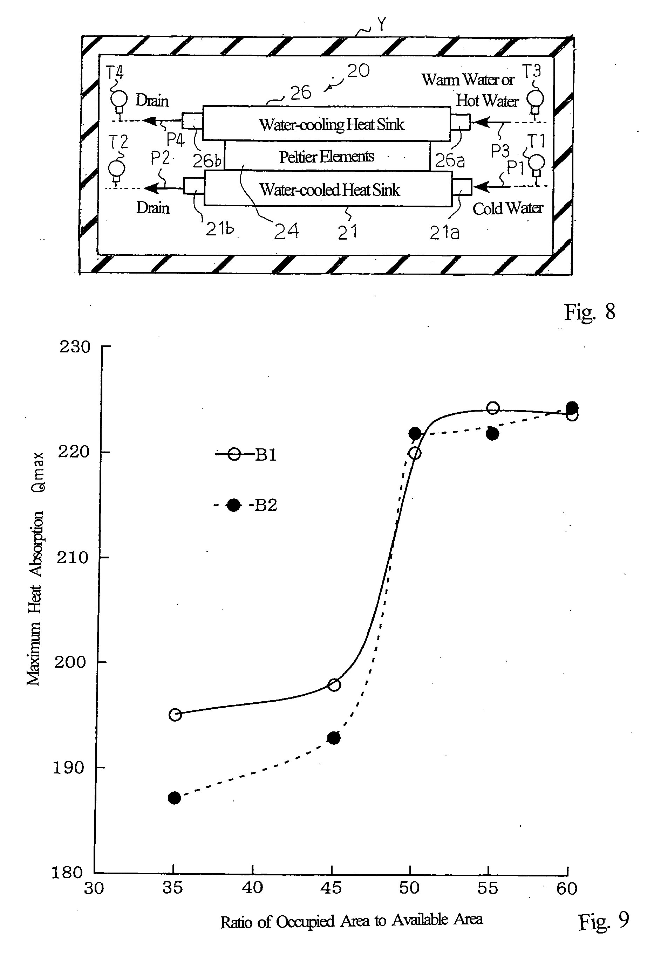

The present inventor further prepared a vacuum vessel shown in figure 8. The vacuum vessel Y had an inner space where each of the samples of thermoelectric module devices 20 were accommodated. A cold water supply pipe P1 was connected to the water inlet 21a, and a drain pile P2 was connected to the water outlet 21b. A hot water supply pipe P3 was connected to the water inlet 26a, and a drain pipe 26b was connected to the water outlet 26b. Temperature gauges T1, T2, T3 and T4 were engaged with the cold water supply pipe P1, drain pipe P2, hot water supply pipe P3 and drain pipe P4, respectively, and the water temperature was monitored with the temperature gauges T1, T2, T3 and T4. The inner space was hermetically closed, and vacuum was developed in the inner space.

An outlet of a source of heat (not shown) was connected to the hot water supply pipe P3 so that warm water or hot water flowed into the water-cooling heat sink 26. The drain pipe P4 was connected to an inlet of the source of heat (not shown) so that the warm water or hot water returned to the source of heat (not shown). Cold water flowed into the water conduit of the water-cooled heat sink 21 through the water inlet 21a, and flowed out through the water outlet 21b. The water temperature was monitored with the temperature gauges T1, T2, T3 and T4. While the thermoelectric module device 20 was operating, the heat was absorbed through the water-cooling heat sink 26, and was transferred to the water-cooled heat sink 21. The cold water was heated through the water-cooled heat sink 21, and the cold water rose in temperature.

The present inventor fitted each of the samples of thermoelectric module device 20 to the water pipes P1, P2, P3 and P4, and started to supply the electric current through the series of p-type semiconductor elements and n-type semiconductor elements of the sample.

The present inventor measured the water temperature for 10 minutes, and calculated the maximum heat absorption Qmax on the basis of the difference between the mean water temperature at T1 and the mean water temperature at T2 and the difference between the mean water temperature at T3 and the mean water temperature at T4. The present inventor determined the maximum temperature absorption Qmax for each of the samples of thermoelectric module device 20, and wrote the amount of maximum heat absorption Qmax in Table 2.

**Table 2**

| | | Maximum Heat Absorption Qmax (Watt) | | | | | Electrically Insulating Layers 22b, 27b | |
|---|---|---|---|---|---|---|---|---|
| Distance t (mm) | | 0.25 | 0.62 | 0.79 | 0.94 | 1.23 | Material (thickness; mm) | Filler |
| Ratio (%) | | 35 | 45 | 50 | 55 | 60 | | |
| Sample | B1 | 195 | 198 | 220 | 224 | 223 | Alumite (5) + Polyimide (30) | AlN |
| | B2 | 187 | 193 | 222 | 222 | 224 | Polyimide (20) | MgO |

In Table 2, term "ratio" means the ratio of the occupied area to the available area, and the available area is identical with the total area of major surface minus non-occupied area. In this experiment, the applied voltage and the amount of current flowing through the samples were as follows.

The voltage, which was applied to sample B1, was 24 volts. The amount of current flowing through sample B1 was varied together with the maximum heat absorption Qmax, and was 8.6 amperes at 195 watts, 8.4 amperes at 198 watts, 8.8 amperes at 220 watts, 9.1 amperes at 224 watts and 9.2 amperes at 223 watts.

The voltage, which was applied to sample B2, was also 24 volts. The amount of current flowing through sample B2 was varied together with the maximum heat absorption Qmax, and was 8.3 amperes at 187 watts, 8.5 amperes at 193 watts, 9.1 amperes at 222 watts, 9.0 amperes at 222 watts and 9.2 amperes at 224 watts.

Figure 9 shows the relation between the maximum heat absorption Qmax and the ratio of occupied area to available area. Bubbles stand for the samples of group B1, and dots stand for the samples of group B2. The plots rapidly ascend between the ratio at 45 % and the ratio at 50 %. Thus, the ratio of occupied area to available area is to be equal to or greater than 50 % on the condition that the ratio of non-occupied area to entire major surface is equal to 14 %. The distance "t" is less than the width of metal electrodes 23 and 25, i.e., 1.8 millimeters.

The reason why the ratio of at least 50 % results in the large amount of maximum heat absorption is the uniformity of temperature dispersion on the heat sinks 21 and 26, i.e., same as that of the thermoelectric module device 10.

Comparing Table 1 with Table 2, it is understood that the difference in ratio of non-occupied area to entire major surface, i.e., 7 % and 14 % does not have influence on the critical percentage of the ratio of occupied area to available area.

### Third Embodiment

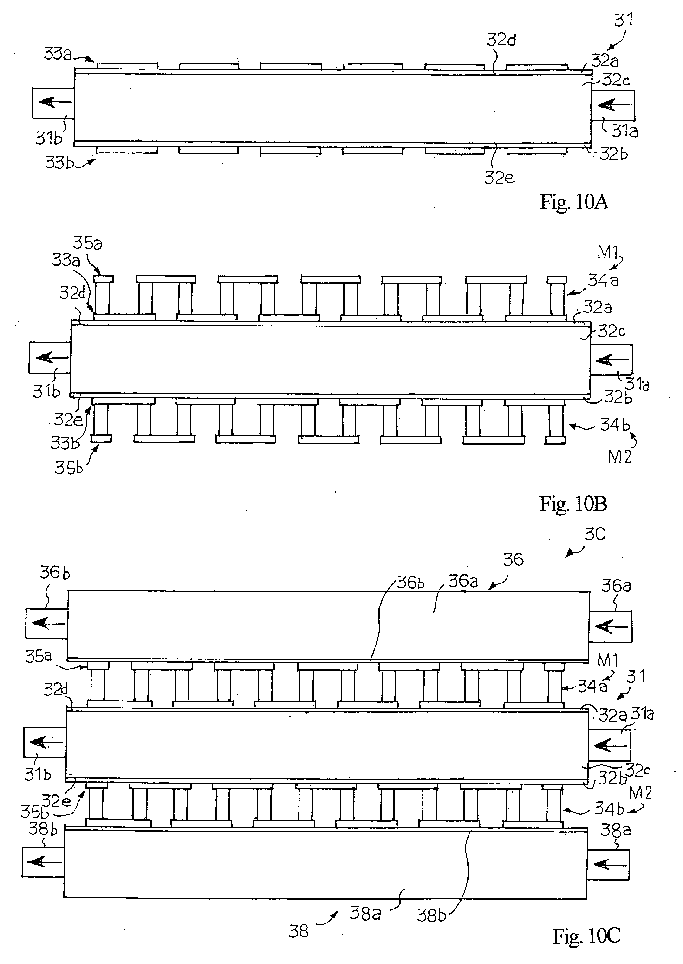

Turning to figures 10A, 10B and 10C, yet another thermoelectric module device 30 of the present invention has intermediate structures at different steps of a fabrication process. The intermediate structure shown in figure 10A is earliest of all, and the intermediate structure shown in figure 10B follows the intermediate structure shown in figure 10A. The intermediate structure shown in figure 10C is fabricated after the intermediate structure shown in figure 10B.

Although the metal electrodes 13/ 23 of thermoelectric module devices 10 and 20 are regularly arranged in rows and columns, it is not always possible to arrange the metal electrodes regularly in rows and columns due to an obstacle on the major surface. Such an irregularly arranged metal electrodes exhibit the above-described tendency of the area ratio.

The thermoelectric module device 30 largely comprises a water-cooling heat sink 31, water-cooled heat sinks 36 and 38 and two series of Peltier elements M1 and M2. The series of Peltier elements M1 is sandwiched between the water-cooling heat sink 31 and the water-cooled heat sink 36, and the other series of Peltier elements M2 is sandwiched between the water-cooling heat sink 31 and the water-cooled heat sink 38.

The water-cooling heat sink 31 has insulating layers 32a and 32b and a metal plate 32c. The metal plate 32c is made of highly heat conductive material such as, for example, aluminum or aluminum alloy, and is formed in a rectangular parallelepiped configuration through a molding. The metal plate 32c has two major surfaces 32d and 32e, and the insulating layers 32a and 32b extend over the major surfaces 32a and 32b, respectively. The top surfaces of insulating layers 32a and 32b are as wide as the major surfaces 32d and 32e, and, for this reason, not only the major surfaces 32d/ 32e but also the top surfaces of insulating layers 32a/ 32b are hereinafter referred to as "major surface". Though not shown in figures 10A to 10C, a water conduit is formed in the metal plate 32c, and a water inlet 31a and a water outlet 31b are connected to both ends of the water conduit. For this reason, water flows into the water conduit through the water inlet 31a, and flows out from the water outlet 31b.

The water-cooled heat sinks 36 and 38 have respective metal plates 36a and 38a and respective insulating layers 36b and 38b. The metal plates 36a and 38a are made of highly heat conductive material such as, for example, aluminum or aluminum alloy, and are formed in a rectangular parallelepiped configuration through a molding. One of the major surfaces of water-cooled heat sink 36 is overlaid by the insulating layer 36b, and, similarly, one of the major surfaces of water-cooled heat sink 38 is overlaid by the insulating layer 38b. The metal plates 36a and 38a are formed with water conduits, respectively, and water inlets 36a and 38a and water outlets 36b and 38b are connected to the water conduits as similar to those of the water-cooling heat sink 31.

The series of Peltier elements M1 includes p-type semiconductor elements 34a, n-type semiconductor elements 34a, endoergic metal electrodes 33a and exoergic metal electrodes 35a. Nickel layers are plated on both end surfaces of each p-type semiconductor element 34a and both end surfaces of each n-type semiconductor element 34a. The endoergic metal electrodes 33a are secured to the insulating layer 32a, and pairs of p-type semiconductor elements and n-type semiconductor elements 34a respectively stand on the endoergic metal electrodes 33a. The p-type semiconductor element and n-type semiconductor element 34a of each pair are spaced from one another on the endoergic metal electrode 33a so that the p-type semiconductor element and n-type semiconductor element 34a of the pair are electrically connected to one another through the endoergic metal electrode 33a. The p-type semiconductor elements and n-type semiconductor elements 34a are soldered to the endoergic metal electrodes 33a. On the other hand, the p-type semiconductor element and n-type semiconductor element 34a on one of the endoergic metal electrode 33a are connected to the n-type semiconductor element 34a on the adjacent endoergic metal electrode 33a and the p-type semiconductor element 34a on another adjacent endoergic metal electrode 33a through the exoergic metal electrodes 35a. The exoergic metal electrodes 35a are soldered to the p-type semiconductor elements and n-type semiconductor elements 34a. SnSb alloy, AuSn alloy or SnAgCu alloy are used as the solder. Power supply cables are connected to the endoergic metal electrode 33a at one end of the series of Peltier elements M1 and to the endoergic metal electrode 33a at the other end of the series of Peltier elements M1. Thus, a dc voltage is applied to the series of Peltier elements M1. The endoergic metal electrodes 33a at both ends of the series of Peltier elements M1 are formed with terminal portions for the power supply cables.

The series of Peltier elements M2 includes p-type semiconductor elements 34b, n-type semiconductor elements 34b, endoergic metal electrodes 33b and exoergic metal electrodes 35b. Nickel layers are plated on both end surfaces of each p-type semiconductor element 34b and both end surfaces of each n-type semiconductor element 34b. The endoergic metal electrodes 33b are secured to the insulating layer 32b, and pairs of p-type semiconductor elements and n-type semiconductor elements 34b respectively stand on the endoergic metal electrodes 33b. The p-type semiconductor element and n-type semiconductor element 34b of each pair are spaced from one another on the endoergic metal electrode 33b so that the p-type semiconductor element and n-type semiconductor element 34b of the pair are electrically connected to one another through the endoergic metal electrode 33b. The p-type semiconductor elements and n-type semiconductor elements 34b are soldered to the endoergic metal electrodes 33b. On the other hand, the p-type semiconductor element and n-type semiconductor element 34b on one of the endoergic metal electrode 33b are connected to the n-type semiconductor element 34b on the adjacent endoergic metal electrode 33b and the p-type semiconductor element 34b on another adjacent endoergic metal electrode 33b through the exoergic metal electrodes 35b. The exoergic metal electrodes 35b are soldered to the p-type semiconductor elements and n-type semiconductor elements 34b. SnSb alloy, AuSn alloy or SnAgCu alloy are used as the solder. The p-type semiconductor elements 34b are altered to the n-type semiconductor elements 34b. In other words, the p-type semiconductor elements 34b and n-type semiconductor elements 34b are alternately found in the series of Peltier elements M2. Power supply cables (not shown) are connected to the endoergic metal electrode 33b at one end of the series of Peltier elements M2 and to the endoergic metal electrode 33b at the other end of the series of Peltier elements M2. Thus, a dc voltage is applied to the series of Peltier elements 24b. The endoergic metal electrodes 33b at both ends of the series of Peltier elements M2 are formed with terminal portions for the power supply cables.

In this instance, the semiconductor elements 14 are made of p-type compound semiconductor and n-type compound semiconductor. Since sintered product of the compound semiconductor in Bi-Te series exhibits good performance at room temperature, Bi-Sb-Te compound semiconductor is employed as the p-type compound semiconductor, and Bi-Sb-Te-Se compound semiconductor is employed as the n-type compound semiconductor. The Bi-Sb-Te compound semiconductor is expressed as Bi₀.₅Sb_{1.5}Te₃, and the Bi-Sb-Te-Se compound semiconductor is expressed as Bi_{1.9}Sb_{0.1}Te_{2.6}Se_{0.4}.

The semiconductor elements 34a and 34b are formed from melted p-type compound semiconductor and melted n-type compound semiconductor as follows. The melted p-type compound semiconductor and melted n-type compound semiconductor are respectively formed into p-type compound semiconductor flakes and n-type compound semiconductor flakes through a liquid quenching method. The p-type compound semiconductor flakes and n-type compound semiconductor flakes are subjected to a hot pressing so that a p-type compound semiconductor bulk and an n-type compound semiconductor bulk are obtained. The p-type compound semiconductor bulk is cut into p-type compound semiconductor columns, and the n-type compound semiconductor bulk is cut into n-type compound semiconductor columns. The p-type compound semiconductor columns and n-type compound semiconductor columns measure 1.35 millimeters in length, 1.35 millimeters in width and 1.5 millimeters in height. Both end surfaces of each p-type compound semiconductor column and both end surfaces of each n-type compound semiconductor column are plated with nickel, and the semiconductor elements 14 are obtained.

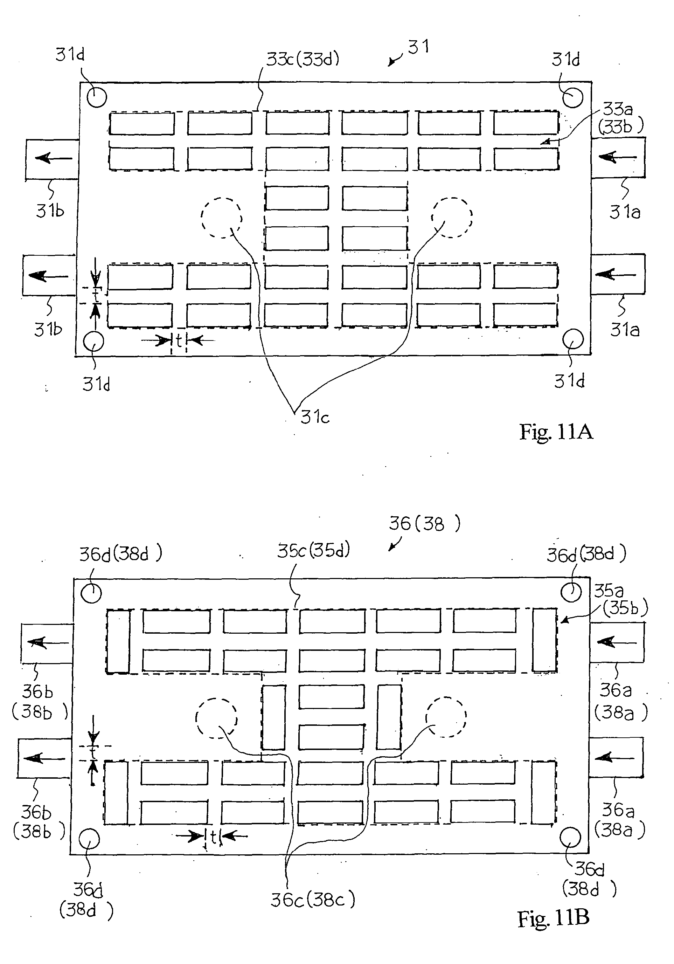

As described hereinbefore, the metal plates 32c, 36a and 38a are formed with the water conduits, and are formed into the rectangular parallelepiped configuration through the molding. The water conduits are formed in the metal plates 32c, 36a and 38a during the molding process, and jigs make additional non-occupied area 31c, 36c and 38c take place in the major surfaces due to grooves and cavities in addition to non-occupied area occupied by fitting holes 31d, 36d and 38d as shown in figures 11A and 11B. The layout of endoergic metal electrodes 33a is identical with the layout of endoergic metal electrodes 33b. The layout of exoergic metal electrodes 35a on the insulating layer 36b is further identical with the layout of exoergic metal electrodes 35b on the insulating layer 38b. For this reason, the reference numerals used in the other layouts are put in parentheses in figures 11A and 11B.

Although the outer rows have the endoergic metal electrodes 33a/ 33b equal to the corresponding outer rows of endoergic metal electrodes 13/ 23, the inner rows have the endoergic metal electrodes 33a/ 33b less than the corresponding inner rows of endoergic metal electrodes 13/ 23. This is because of the non-occupied areas 31c. Only the area between the non-occupied areas 31c is available for the endoergic metal electrodes 33a/ 33b. Therefore, envelope surfaces 33c/ 33d are constricted at the inner rows. Similarly, envelope surfaces 35c/ 35d are constricted at the inner rows. Thus, the non-occupied areas 31c/ 31d increase the amount of non-occupied area, and make the available areas decreased. Each of the areas enclosed with the envelope surface 33c, 33d, 35c and 35d is referred to as "occupied area.

In this instance, the total of non-occupied areas 31c/ 31d, 36c/ 36d or 38c/ 38d is equal to 18 percent of the major surface, and is less than the critical value, i.e., 20 percent. The ratio of occupied area 33c, 33d, 35c or 35d to available area is equal to or greater than 50 percent.

The insulating layers 32a, 32b, 36b and 38b are, by way of example, made of polyimide resin, epoxy resin or alumite, and are fallen within the range from 10 µm to 100 µm. The insulating layers 32a, 32b, 36b and 38b have adhesiveness. In case where the insulating layers 32a, 32b, 36b and 38b are made of polyimide resin or epoxy resin, it is preferable to disperse alumina powder, aluminum nitride powder, magnesium oxide powder or silicon carbide powder in the synthetic resin for enhancing the heat conductivity of insulating layers 32a, 32b, 36b and 38b. The dispersed powder has the grain size or mean diameter equal to or less than 15 µm. In case where the insulating layers 32a, 32b, 36b and 38b are made of alumite, it is desirable to cover the top surfaces of alumite layers with the powder-containing polyimide resin layer or powder-containing epoxy resin layer.

The endoergic metal electrodes 33a/ 33b and exoergic metal electrodes 35a/ 35b are made of copper or copper alloy, and the thickness of metal electrodes 33a, 33b, 35a and 35b is fallen within the range from 70 µm to 200 µm. The endoergic metal electrodes 33a/ 33b and exoergic metal electrodes 35a/ 35b have respective rectangular top surfaces, and the rectangular top surfaces measure 3 millimeters in length and 1.8 millimeters in width. The distance "t" between the adjacent metal electrodes 33a, 33b, 35a, 35b is less than the width of metal electrodes 33a, 33b, 35a and 35b, i.e., 1.8 millimeters. The

The thermoelectric module device 30 is fabricated as follows. First, the water-cooling heat sink 31, in which the water conduit has been formed, is prepared through a step where the metal plate 32c is sandwiched between the insulating layers 32a and 32b. Further, the water-cooled heat sinks 36 and 38, in which the water conduits have been respectively formed, are prepared through a step where the major surfaces of metal plates 36a and 38a are overlaid with the insulating layers 36b and 38b, respectively. In case where the insulating layers 32a, 32b, 36b and 38b have been formed in synthetic resin layers, the synthetic resin layers are pressed to the major surfaces of metal plates 32c, 36a and 38a. On the other hand, in case where synthetic resin paste is used, the synthetic resin paste is spread over the major surfaces of metal plates 32c, 36a and 38a, and the synthetic resin paste layers are solidified. The metal electrodes 34a, 34b, 35a and 35b, p-type semiconductor elements 34a and 34b and n-type semiconductor elements 34a and 34b are prepared.

Subsequently, the metal endoergic electrodes 33a and 33b are laid on the pattern in the envelope surfaces 33c and 33d, and are adhered to the insulating layers 32a and 32b as shown in figure 10A. The pairs of p-type semiconductor elements and n-type semiconductor elements 34a and 34b are put on the endoergic metal electrodes 33a and 33b, and are soldered to the endoergic metal electrodes 33a and 33b. Subsequently, the exoergic metal electrodes 35a and 35b are laid on the pattern in the envelope surfaces 35c and 35d, and are soldered to the p-type semiconductor elements 34a/ 34b and n-type semiconductor elements 34a/ 34b as shown in figure 10B. Thus, the series of Peltier elements M1 and the series of Peltier elements M2 are fabricated on the water-cooling heat sink 31.

Subsequently, the water-cooled heat sinks 36 and 38 are opposed to the exoergic metal electrodes 35a and 35b, and the exoergic metal electrodes are adhered to the insulating layers 36b and 38b as shown in figure 10C.

The present inventor investigated the thermoelectric module device 30. The present inventor prepared two sample groups C1 and C2 of the thermoelectric module device 30.

The samples of the first sample group C1 had the insulating layers 32a, 32b, 36b and 38b of alumina powder containing polyimide resin, and the insulating layers 32a, 32b, 36b and 38b were 15 µm thick. The distance "t" and the ratio of occupied area to available area were different among the samples as written in Table 3.

On the other hand, the insulating layers 32a, 32b, 36b and 38b of the samples of the second sample group C2 had the multiple layered structure, and each of the insulating layers 32a, 32b, 36b and 38b had the alumite layer of 10 µm thick and the powder containing epoxy resin layer of 20 µm thick. The powder or filler was mixture of alumina powder and aluminum nitride powder.

The endoergic metal electrodes 33a and 33b and the exoergic metal electrodes 35a and 35b of all the samples were made of copper, and had the thickness of 120 µm. Each of the metal plates 32c, 36a and 38a was made of aluminum, and was 100 millimeters in width, 120 millimeters in length and 15 millimeters in thickness. Each of the two series M1 and M2 was formed from 504 pairs of p-type semiconductor elements and n-type semiconductor elements 34a or 34b.

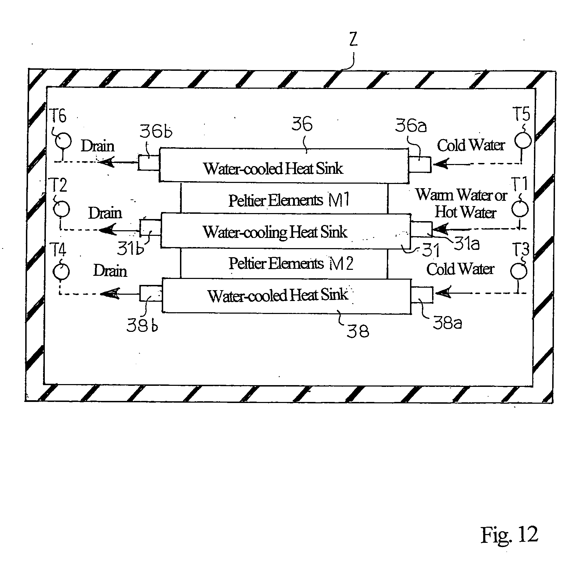

The present inventor further prepared a vacuum vessel Z shown in figure 12, and each of the samples was put in the vacuum chamber of vacuum vessel Z. Though not shown in figure 12, a source of heat and a source of cold water were provided in association with the vacuum vessel Z, and temperature gauges T1, T2, T3, T4, T5 and T6 were provided inside the vacuum vessel Z.

The water outlet of source of heat (not shown) was connected to the water inlet 31 a, and the water outlet 32b was connected to the water inlet of source of heat (not shown). While the source of heat was generating heat, warm water or hot water flowed into the water conduit of water-cooling heat sink 31, and drain returned to the source of heat. The temperature of warm water/ hot water and the temperature of drain were measured with the temperature gauges T1 and T2.

The water inlet 36a was connected to a source of cold water (not shown), and the water outlet 36b was connected to a drain pipe. Cold water flowed into the water conduit of water-cooled heat sink 36, and warm water flowed out from the water conduit. The temperature of cold water and the temperature of drain were measured with the temperature gauges T5 and T6.

The water inlet 38a was connected to the source of cold water (not shown), and the water outlet 38b was connected to a drain pipe. Cold water flowed into the water conduit of water-cooled heat sink 38, and warm water flowed out from the water conduit. The temperature of cold water and the temperature of drain were measured with the temperature gauges T3 and T4. The dc voltage was applied to both of the series of Peltier elements M1 and M2.

The source of heat (not shown) generated the heat, and the hot water was supplied to the water-cooling heat sink 31. The cold water was supplied to the water-cooled heat sinks 36 and 38. Then, the series of Peltier elements M1 and M2 absorbed the heat from the hot water through the water-cooling heat sink 31, and the absorbed heat was transferred to the cold water through the water-cooled heat sinks 36 and 38.

The present inventor measured the temperature of hot water, temperature of cold water and temperature of drain water for ten minutes, and calculated the maximum heat absorption Qmax on the basis of mean temperature of hot water, mean temperature of cold water and mean temperature of drain water as similar to the calculation for the samples A1, A2, A3 and A4. The maximum heat absorption Qmax of samples were written in Table 3.

### (blank)

**Table 3**

| | | Maximum Heat Absorption Qmax (Watt) | | | | | Electrically Insulating Layers 32a, 32b, 36b, 38b | |
|---|---|---|---|---|---|---|---|---|
| Distance t (mm) | | 0.30 | 0.67 | 0.85 | 1.00 | 1.15 | Material (thickness; mm) | Filler |
| Ratio (%) | | 35 | 45 | 50 | 55 | 60 | | |
| Sample | C1 | 399 | 401 | 443 | 445 | 445 | Polyimide (15) | Al₂O₃ |
| | C2 | 403 | 407 | 445 | 445 | 447 | Alumite (5) + Epoxy (20) | Al₂O₃ + AlN |

In Table 3, term "ratio" means the ratio of the occupied area to the available area, and the available area is identical with the total area of major surface minus total of non-occupied area. In this experiment, the applied voltage and the amount of current flowing through the samples were as follows.

The voltage, which was applied to sample C1, was 48 volts. The amount of current flowing through sample C1 was varied together with the maximum heat absorption Qmax, and was 9.1 amperes at 399 watts, 9.1 amperes at 401 watts, 9.5 amperes at 443 watts, 9.3 amperes at 445 watts and 9.5 amperes at 445 watts.

The voltage, which was applied to sample C2, was also 48 volts. The amount of current flowing through sample C2 was varied together with the maximum heat absorption Qmax, and was 8.9 amperes at 403 watts, 8.7 amperes at 407 watts, 9.4 amperes at 445 watts, 9.4 amperes at 445 watts and 9.4 amperes at 447 watts.

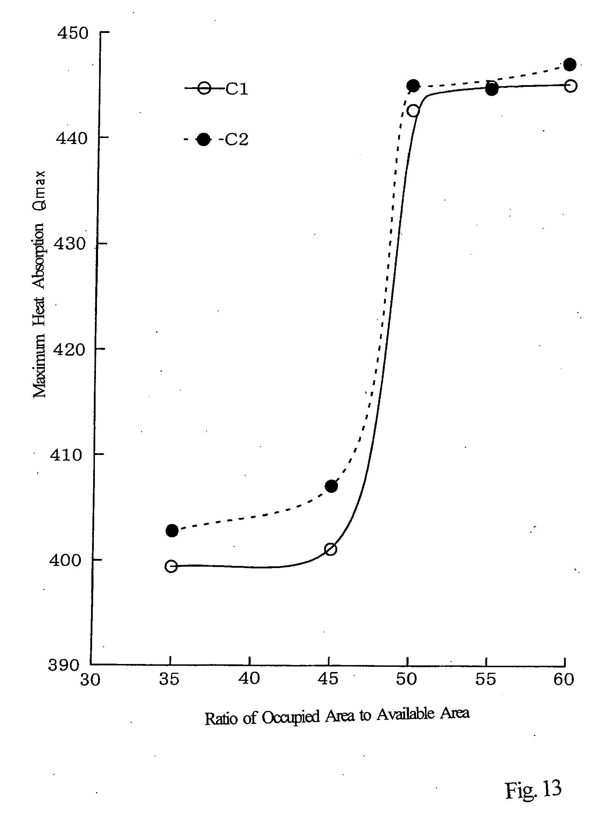

Figure 13 shows the relation between the maximum heat absorption Qmax and the ratio of occupied area to available area. Bubbles stand for the samples of group C1, and dots stand for the samples of group C2. The plots rapidly ascend between the ratio at 45 % and the ratio at 50 %. Thus, the ratio of occupied area to available area is to be equal to or greater than 50 % on the condition that the ratio of non-occupied area to entire major surface is equal to 18 %. The distance "t" is less than the width of metal electrodes 32a, 32b, 35a and 35b, i.e., 1.8 millimeters.

The reason why the ratio of at least 50 % results in the large amount of maximum heat absorption Qmax is the uniformity of temperature dispersion on the heat sinks 31, 36 and 38.

Comparing Table 3 with Tables 2 and 3, it is understood that the difference in ratio of non-occupied area to entire major surface, i.e., 18% and 7 %/ 14 % does not have influence on the critical percentage of the ratio of occupied area to available area.

Subsequently, the present inventor investigated the thermoelectric module device for the ratio of non-occupied area to entire major surface. The present inventor prepared samples D of the thermoelectric module device 10.

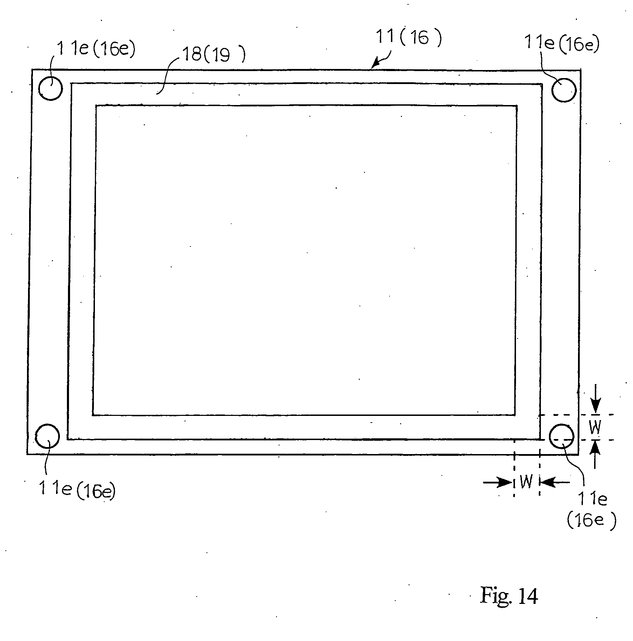

Although the grooves for the vapor-proof sealing walls are omitted from the figures showing the thermoelectric module device 10, the grooves 18 and 19 are shown in figure 14 for the samples D. Though now shown in the drawings, vapor-proof sealing walls (not shown) are seated at both end portions on the bottoms of grooves 18 and 19. As a result, the vapor-proof sealing walls extend over the gap between the heat sinks 11 and 16, and the series of Peltier elements is enclosed with the vapor-proof sealing walls. In this instance, the vapor-proof sealing walls (not shown) are made of butyl rubber.

The grooves 18 and 19 were formed along the outer peripheries of heat sinks 11 and 16, and the occupied area was enclosed with the grooves 18 and 19. The occupied area inside the envelope surfaces 13a/ 15a of samples D was adjusted to 60 % of the available area. The present inventor made the width W of grooves 18 and 19 different among the samples D as written in Table 4, and the distance "t" between the adjacent metal electrodes 13/ 15 was further different among the samples D.

The metal electrodes 13 and 15 were made of copper, and were 120 µm thick. The heat sinks 11 and 16 were made of aluminum, and measured 90 millimeters in length and 90 millimeters in width. The fins 11a were 40 millimeters in height. The insulating layers 12 and 17 had the multiple layered structure, which had an alumite layer of 5 µm and an aluminum nitride powder-containing epoxy resin layer of 30 µm. 320 pairs of p-type semiconductor elements and n-type semiconductor elements formed the series of Peltier elements PLT.

The present inventor fitted the samples D in the window of the heat insulating box X, and drove the fans for the forced air cooling. The present inventor determined the maximum heat absorption Qmax as similar to the samples A1 to A4. The amount of maximum heat absorption Qmax was written in Table 4.

**Table 4**

| Insulating Layers 12, 17 | Alumite (5) + Epoxy (30) + AlN filler | | | | | |
|---|---|---|---|---|---|---|
| Distance t between Electrodes (mm) | 1.51 | 1.38 | 1.25 | 1.20 | 1.11 | 0.97 |
| Ratio of non-occupied area to entire major surface (%) | 6 | 12 | 18 | 20 | 24 | 30 |
| Maximum heat absorption Qmax (watt) | 72 | 70 | 72 | 71 | 52 | 48 |

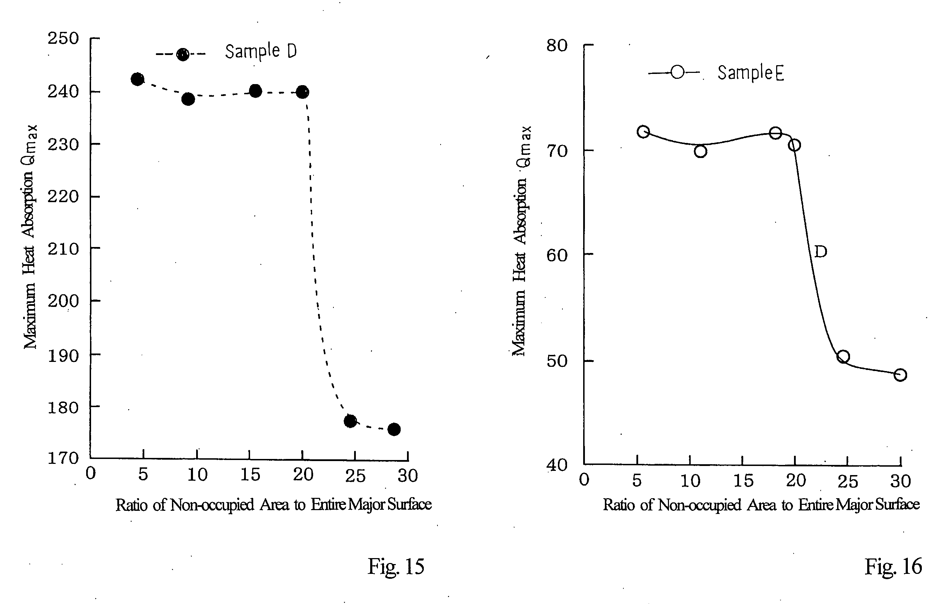

The present inventor plotted the maximum heat absorption Qmax in terms of the ratio of non-occupied area as shown in figure 15. As will be understood from figure 15, plots drastically descend between the ratio of 20 % and the ratio of 25 %. Thus, the ratio of non-occupied area is to be equal to or less than 20 %.

The present inventor further made the investigation for the ratio of non-occupied area by using the thermoelectric module device 30. The present inventor prepared samples E, and made the samples E different in width of grooves from one another. The present inventor made the distance "t" between the adjacent metal electrodes 33a/ 33b/ 35a/ 35b different from one another as shown in Table 5, and adjusted the ratio of occupied area to available area of samples E to 55 %.

552 pairs of p-type semiconductor elements and n-type semiconductor elements 34a/ 34b formed the series of Peltier elements M1 and M2. The metal electrodes 33a, 33b, 35a and 35b were made of copper, and were 120 µm in thickness. The metal plates 32c, 36a and 38a were made of aluminum, and measured 110 millimeters in width, 130 millimeters in width and 15 millimeters in thickness. The insulating layer had the multiple-layered structure, and an alumite layer of 5 µm thick and an aluminum nitride powder-containing epoxy resin layer of 30 µm thick formed the multiple layered structure.

The present inventor determined the maximum heat absorption Qmax as similar to the samples C1 and C2, and the experimental results were written in Table 5.

**Table 5**

| Insulating Layers 12, 17 | Alumite (5) + Epoxy (30) + AlN filler | | | | | |
|---|---|---|---|---|---|---|
| Distance t between Electrodes (mm) | 1.54 | 1.45 | 1.30 | 1.18 | 1.10 | 1.00 |
| Ratio of non-occupied area to entire major surface (%) | 4 | 8 | 16 | 20 | 24 | 28 |
| Maximum heat absorption Qmax (watt) | 242 | 239 | 241 | 241 | 178 | 176 |

The present inventor plotted the maximum heat absorption Qmax in terms of the ratio of non-occupied area as shown in figure 16. As will be understood from figure 15, plots drastically descend between the ratio of 20 % and the ratio of 24 %. Thus, the ratio of non-occupied area is to be equal to or less than 20 %.

As will be appreciated from the foregoing description, Tables 1 to 5 and figures 5, 9, 13, 15 and 16, the thermoelectric module device exhibits the good heat transfer characteristics on the condition that the ratio of occupied area to available area is equal to or greater than 50 % and that the ratio of non-occupied area to the entire major surface is equal to or less than 20 %.

Although particular embodiments of the present invention have been shown and described, it will be apparent to those skilled in the art that various changes and modifications may be made without departing from the spirit and scope of the present invention.

The electrically insulating layers 12 and 17 may have a multi-layered structure. For example, the insulating alloy layer is overlaid with the filler-containing insulating synthetic resin layer.

The metal plates 22a and 26a may be made of other sorts of highly heat conductive alloy such as, for example, aluminum alloy.

The epoxy resin and polyimide resin do not set any limit to the technical scope of the present invention. The insulating layer may be made of other sorts of synthetic resin such as, for example, aramide resin except for the polyimide and epoxy and BT (Bismulade Triazine) resin.

The filler may be other sorts of powder such as, for example, carbon powder, silicon carbide powder and silicon nitride powder. More than two sorts of powder may be mixed for the filler. The powder may be spherical, needlelike or mixture of spherical configuration and needlelike configuration.

The compound semiconductor in Bi-Te series does not set any limit to the technical scope of the present invention. Other sorts of semiconductor, a combination of different sorts of metal or a combination of semiconductor and metal may be used for the series of Peltier elements PLT, M1 and M2.

The forced air cooling and water-cooling do not set any limit to the technical feature of the present invention. A thermoelectric module device of the present invention may work in natural air cooling.

The water does not set any limit to the technical scope of the present invention. Another sort of liquid such as, for example, refrigerant may flow through the water-conduits.

Although all of the Peltier elements are connected in series in the above-described embodiments, the series connection is not an indispensable feature of the present invention. For example, the Peltier elements may be divided in plural groups so as electrically connect the plural groups in parallel.

The insulating layers 12, 17, 22b, 27b, 32a, 32b, 36b and 38b are not indispensable elements of the thermoelectric module device of the present invention. The reason why the insulating layers 12, 17, 22b, 27b, 32a, 32b, 36b and 38b are required between the metal electrodes and the mounting portions/ metal plates is that the mounting portions/ metal plates of electrically conductive metal or electrically conductive alloy make the series of Peltier elements short-circuited. In case where the mounting portions/ metal plates are made of thermally-conductive electrically-insulating material, the insulating layers 12, 17, 22b, 27b, 32a, 32b, 36b and 38b are not required for the thermoelectric module devices.

The samples A1, A2, A3, A4, B1, B2, C1, C2, D and E fulfill both of the conditions of ratio of occupied area and ratio of non-occupied area. However, even if a thermoelectric module device fulfills one of the conditions, i.e., either ratio of occupied area or ratio of non-occupied area, the thermoelectric module device exhibits the maximum heat absorption Qmax better than a thermoelectric module device, which does not fulfill both of the conditions.

The component parts of above-described thermoelectric module devices 10, 20 and 30 are correlated with claim languages as follows.

One of the first heat sink 11 and second heat sink 16 and one of the water-cooling heat sink 21/ 31 and water-cooled heat sink 26/ 36/ 38 serve as a "first heat sink", and the other the first heat sink 11 and second heat sink 16 and the other of the water-cooling heat sink 21/31 and water-cooled heat sink 26/ 36/ 38 serve as a "second heat sink".

The top surfaces of insulating layers over the major surfaces 11c and 16c serve as a "major surface" and "another major surface", and the surface of fins 11a and surfaces of fins 16a serve as a "heat exchanging surface" and "another heat exchanging surface." The top surfaces of insulating layers over the major surfaces 22c and 27c also serve as the "major surface" and "another major surface", and the inner surfaces defining the water conduits serve as the "heat exchanging surface" and "another heat exchanging surface." The top surfaces of insulating layers over the major surfaces 32d and 32e serve as one of the "major surface" and "another major surface", and the top surfaces of insulating layers 36b and 38b serve as the other of the "major surface" and "another major surface". The inner surfaces defining the water-conduits serve the "heat exchanging surface" and "another heat exchanging surface."

The series of Peltier elements PLT, M1 and M2 is corresponding to a "group of thermoelectric elements." The occupied area, available area and non-occupied area are same in meaning as a "occupied area", an "available area" and a "non-occupied area." At least the fitting holes 11e/ 16e/ 21b/ 26b/ 31d/ 36d/ 38d occupy a "non-occupied area" and "another non-occupied area", and grooves 18/ 19 and the fitting holes 11e/ 16e/ 21b/ 26b/ 31d/ 36d/38d occupy the "non-occupied area" and "another non-occupied area." The coupling members CP are corresponding to "coupling members."

The fins 11a and fins 16a serve as a "heat exchange accelerating facility" and "another heat exchange accelerating facility", and the inner surfaces, which define the water conduits, also serve as the "heat exchange accelerating facility" and "another heat exchange accelerating facility." The water conduits, the water inlet and water outlet of which are labeled with 21a/ 21b/26a/ 26b and 31a/ 31b/ 36a/ 36b/ 38a/ 38b are corresponding to a "conduit" and "another conduit", and the water serves as "liquid" and "another liquid".

The p-type semiconductor elements 14, 24a, 34a and 34b are corresponding to "pieces of semiconductor of one conductivity type", and the n-type semiconductor elements 14, 24a, 34a and 34b serve as "pieces of semiconductor of the other conductivity type."

Each of the mounting portion 11b, water-cooled heat sink 21/ 36/ 38 and water-cooling heat sink 36/ 31 is corresponding to a "mounting portion" of claims defining a heat exchanger, and each of the metal portions 22a/ 27a/32c/ 36a/ 38a serves as a "base portion".

## Claims

1. A thermoelectric module device (10; 20; 30) for transferring heat from a cold side to a hot side, comprising:
a first heat sink (16; 26; 31) having a thermally conductive property and an electrically insulating property, and having a major surface and a heat exchanging surface (16a; 26a/ 26b; 31a/ 31b) serving as one of said cold side and hot side;
a second heat sink (11; 21; 36/ 38) having a thermally conductive property and an electrically insulating property, and having another major surface and another heat exchanging surface (11a; 21a/ 21b; 36a/ 36b/ 38a/38b) serving as the other of said cold side and hot side; and
a group (PTL; 24; M1/ M2) of thermoelectric elements (14; 24a; 34a/34b) provided between said major surface and said another major surface, occupying an occupied area (15a; 25a; 35c/ 35d) in said major surface and another occupied area (13a; 23a; 33c/ 33d) in said another major surface, and applied with voltage so as to transfer heat between said first heat sink (16; 26; 31) and said second heat sink (11; 21; 36/ 38),
wherein said major surface and said another major surface have an available area possible to be occupied by said group (PLT; 24; M1/ M2) of thermoelectric elements (14; 24a; 34a/ 34b) and another available area possible to be occupied by said group (PLT; 24; M1/ M2) of thermoelectric elements (14; 24a; 34a/ 34b), respectively,
**characterized in that**
a ratio between said occupied area and said available area and a ratio between said another occupied area and said another available area are equal to or greater than 50 percent.

2. The thermoelectric module device as set forth in claim 1, in which a non-occupied area and another non-occupied area are equal to a difference between an area of said major surface and said available area and a difference between an area of said another major surface and said another available area, respectively, and a ratio between said non-occupied area and said major surface and a ratio between said another non-occupied area and an area of said another major surface are equal to or less than 20 percent.

3. The thermoelectric module device as set forth in claim 1, in which the thermoelectric elements (14; 24a; 34a/ 34b) of said group (PLT; 24; M1/M2) are arranged in rows and columns, and said occupied area and said another occupied area are equal to an area defined by an envelope (15a/ 13a; 25a/ 23a; 35c/ 35d/ 33c/ 33d) with which said rows and columns of said thermoelectric elements (14; 24a; 34a/ 34b) are enclosed.

4. The thermoelectric module device as set forth in claim 3, in which each of said thermoelectric elements (14; 24a; 34a/ 34b) occupies an area having a planar configuration defined by lengths, and is spaced from the adjacent thermoelectric elements in the same row and in the same column by a distance (t) shorter than shorter one of said lengths of said planar configuration.

5. The thermoelectric module device as set forth in claim 1, in which said first heat sink (16; 26; 31) and said second heat sink (11; 21; 36/ 38) have respective electrically insulating layers (17/ 21; 27b/ 22b; 32a/ 32b/ 36b/38b) and respective mounting portions (11b/ 16b; 27a/ 22a; 32c/ 36a/ 38a) made of material having electrically conductive property and thermally conductive property and respectively covered with said electrically insulating layers (17/ 21; 27b/ 22b; 32a/ 32b/ 36b/ 38b).

6. The thermoelectric module device as set forth in claim 5, in which said electrically insulating layers (17/ 21; 27b/ 22b; 32a/ 32b/ 36b/ 38b) are made of synthetic resin having electrically insulating property, and contain filler having thermally conductive property for improving the heat conductive property of said insulating layers (17/ 21; 27b/ 22b; 32a/ 32b/ 36b/ 38b).

7. The thermoelectric module device as set forth in claim 1, in which said first heat sink (16; 26; 31) and said second heat sink (11; 21; 36/ 38) have a heat exchange accelerating facility (16a; 26a/ 26b; 31a/ 31 b) serving as said heat exchanging surface and another heat exchange accelerating facility (11a; 21a/ 21b; 36a/ 36b/ 38a/ 38b) serving as said another heat exchanging surface, respectively.

8. The thermoelectric module device as set forth in claim 7, in which said first heat sink (16) and said second heat sink (11) are respectively formed with fins (16a) serving as said heat exchange accelerating facility and other fins (11a) serving as said another heat exchange accelerating facility.

9. The thermoelectric module device as set forth in claim 7, in which said first heat sink (26; 31) and said second heat sink (21; 36/ 38) are respectively formed with a conduit (26a/ 26b; 31a/ 31b) for liquid and another conduit (21a/ 21b; 31a/ 31b) for another liquid, and an inner surface defining said conduit (25a/ 26b; 31a/ 31b) and another inner surface defining said another conduit (21a/ 21b; 31a/ 31b) serve as said heat exchange accelerating facility and said another heat exchange accelerating facility, respectively.

10. The thermoelectric module device as set forth in claim 1, in which the group (PLT; 24; M1/ M2) of thermoelectric elements (14; 24a; 34a/ 34b) has pieces of semiconductor of one conductivity type, other pieces of semiconductor of the other conductivity type and conductive electrodes (13/ 15; 23/25; 33a/ 33b/ 35a/ 35b) interconnecting said pieces of semiconductor of one conductivity type and said pieces of semiconductor of the other conductivity type.

11. The thermoelectric module device as set forth in claim 10, in which the semiconductor of one conductivity type and the semiconductor of the other conductivity type are compound semiconductor different in chemical formula from one another.

12. A heat exchanger used for a group (PLT; 24; M1 / M2) of thermoelectric elements (14; 24a; 34a/ 34b), comprising:
a mounting portion (11b/ 12; 16b/ 17; 22a/ 22b; 27a/ 27b; 32a/ 32c; 36a/ 36b/ 38a/ 38b) having
a major surface containing an available area possible to be occupied by said group (PLT; 24; M1/ M2) of thermoelectric elements (14; 24a; 34a/34b); and
a heat exchanging surface (11a; 16a; 21a/ 21b; 26a/ 26b; 31a/ 31b; 36a/ 36b/ 38a/ 38b) held in contact with medium at certain temperature different from the temperature of said major surface,
**characterized in that**
a ratio between said available area and an occupied area (13a; 15a; 23a; 25a; 33c/ 33d; 35c/ 35d) occupied by said group (PLT; 24; M1/ M2) of thermoelectric elements (14; 24a; 34a/ 34b) is equal to or greater than 50 percent.

13. The heat exchanger as set forth in claim 12, in which a non-occupied is equal to a difference between an area of said major surface and said available area, and a ratio between said non-occupied area and said major surface is equal to or less than 20 percent.

14. The heat exchanger as set forth in claim 12, in which each of the thermoelectric elements (14; 24a; 34a/ 34b) of said group (PLT; 24; M1/ M2) occupies an area having a planar configuration defined by lengths, and is spaced from the adjacent thermoelectric elements (14; 24a; 34a/ 34b) by a distance (t) shorter than shorter one of said lengths of said planar configuration.

15. The heat exchanger as set forth in claim 12, in which said mounting portion has an electrically insulating layer (12; 17; 22b; 27b; 32a/ 32b; 36b/38b) and a base portion (11b; 16b; 22a; 27a; 32c; 36a/ 38a) made of material having electrically conductive property and thermally conductive property and covered with said electrically insulating layer (12; 17; 22b; 27b; 32a/32b; 36b/ 38b).
